# EUROPEAN PATENT APPLICATION

(11) **EP 4 120 321 A1**
(43) Date of publication of application: **18.01.2023**
(21) Application number: 22159426.0
(22) Date of filing: 01.03.2022
(51) Int. Cl.: H01L 21/28, H01L 27/1159, H01L 29/423, H01L 29/51, H01L 29/66, H01L 29/78

(54) **MEMORY CELLS WITH NON-PLANAR FERROELECTRIC OR ANTIFERROELECTRIC MATERIALS**

(30) Priority: 12.07.2021 US 202117372612
(71) Applicant: Intel Corporation, Santa Clara, CA 95054 (US)
(72) Inventor: SHARMA, Abhishek, Hillsboro, 97124 (US); LE, Van, Beaverton, 97007 (US); DOYLE, Brian, Portland, 97229 (US); MAJHI, Prashant, San Jose, 95121 (US)
(74) Representative: Goddar, Heinz J.

(57) **Abstract**

Memory cells with non-planar memory materials that include ferroelectric (FE) or anti-ferroelectric (AFE) materials are described. An example memory cell includes a transistor (110) provided over a support structure (302), where a memory material (312) is integrated with a transistor gate (304). The channel material (306) and the memory material (312) are non-planar in that each includes a horizontal portion substantially parallel to the support structure, and a first and a second sidewall portions, each of which is substantially perpendicular to the support structure, where the horizontal portion of the memory material is between the horizontal portion of the channel material and a gate electrode material of the transistor gate, the first sidewall of the memory material is between the first sidewall of the channel material and the gate electrode material, and the second sidewall of the memory material is between the second sidewall of the channel material and the gate electrode material.

## Description

### Background

Embedded memory is important for future generation microprocessors and system-on-a-chip (SoC) technology. Memory cells with thin-film ferroelectric (FE) or antiferroelectric (AFE) materials pave the way for a promising technology that can enable viable embedded memory solutions.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is an electric circuit diagram of a memory cell in which a non-planar memory material is integrated with a transistor gate, according to some embodiments of the present disclosure.
FIG. 2 is an electric circuit diagram of an array of a plurality of memory cells of FIG. 1, according to some embodiments of the present disclosure.
FIGS. 3A-3C provide various views of an example integrated circuit (IC) device implementing a memory cell of FIG. 1 with a bottom-gated transistor according to a first embodiment of the present disclosure.
FIGS. 4A-4E provide various views of an example IC device implementing a memory cell of FIG. 1 with a bottom-gated transistor according to a second embodiment of the present disclosure.
FIGS. 5A-5D provide various views of an example IC device implementing a memory cell of FIG. 1 with a vertical transistor according to a third embodiment of the present disclosure.
FIGS. 6A-6C provide various views of an example IC device implementing a memory cell of FIG. 1 with a top-gated transistor according to a fourth embodiment of the present disclosure.
FIGS. 7A-7E provide various views of an example IC device implementing a memory cell of FIG. 1 with a top-gated transistor according to a fifth embodiment of the present disclosure.
FIG. 8 is a flow diagram of a first example method for fabricating an IC device with one or more memory cells with non-planar memory materials in accordance with various embodiments of the present disclosure.
FIG. 9 is a flow diagram of a second example method for fabricating an IC device with one or more memory cells with non-planar memory materials in accordance with various embodiments of the present disclosure.
FIGS. 10A-10B are top views of a wafer and dies that may include one or more memory cells with non-planar memory materials in accordance with any of the embodiments disclosed herein.
FIG. 11 is a cross-sectional side view of an IC device that may include one or more memory cells with non-planar memory materials in accordance with any of the embodiments disclosed herein.
FIG. 12 is a cross-sectional side view of an IC package that may include one or more memory cells with non-planar memory materials in accordance with any of the embodiments disclosed herein.
FIG. 13 is a cross-sectional side view of an IC device assembly that may include one or more memory cells with non-planar memory materials in accordance with any of the embodiments disclosed herein.
FIG. 14 is a block diagram of an example computing device that may include one or more components having memory cells with non-planar memory materials in accordance with any of the embodiments disclosed herein.

### Detailed Description

Described herein are FE memory cells and corresponding methods and devices. In general, the term "FE memory" typically refers to a memory technology employing FE or AFE materials. A FE or an AFE material is a material that exhibits, over some range of temperatures, spontaneous electric polarization, i.e., displacement of positive and negative charges from their original position, where the polarization can be reversed or reoriented by application of an electric field. In particular, an AFE material is a material that can assume a state in which electric dipoles from the ions and electrons in the material may form a substantially ordered (e.g., substantially crystalline) array, with adjacent dipoles being oriented in opposite (antiparallel) directions (i.e., the dipoles of each orientation may form interpenetrating sub-lattices, loosely analogous to a checkerboard pattern), while a FE material is a material that can assume a state in which all of the dipoles point in the same direction. Because the displacement of the charges in FE and AFE materials can be maintained for some time even in the absence of an electric field, such materials may be used to implement memory cells. The term "ferroelectric" is said to be adopted to convey the similarity of FE memories to ferromagnetic memories, despite the fact that there is typically no iron (Fe) present in FE materials.

FE memories have the potential for adequate non-volatility, short programming time, low power consumption, high endurance, and high speed writing. In addition, FE memories have the potential to be manufactured using processes compatible with the standard complementary metal-oxide-semiconductor (CMOS) technology. Therefore, over the last few years, these types of memories have emerged as promising candidates for many growing applications, e.g., digital cameras and contactless smart cards.

Commercial viability of FE memories depends on a number of factors. One factor is the ability to improve FE properties of FE memory cells without increasing the cell size. Decreasing the critical voltage (Vc) that needs to be applied for FE switching of a FE memory cell is one example of a desired improvement in FE properties that could help commercial viability of FE memories. One approach to decreasing Vc includes engineering superior FE and AFE materials. However, such an approach is extremely difficult. Another approach includes decreasing the thickness of a gate dielectric material in a FE memory cell. However, decreasing the dielectric thickness may also cause the threshold voltage change between written and erase states to decrease, making it more problematic to get FE memory arrays to function because device variations make the switching window very tight. Other approaches involve complex fabrication sequences, increasing fabrication costs and hindering large-scale adoption of the technology.

Memory cells with non-planar FE or AFE materials (together referred to herein as "memory materials"), proposed herein, may improve on one of more challenges described above. An example memory cell includes a transistor, e.g., a field-effect transistor (FET) such as a metal-oxide-semiconductor FET (MOSFET), provided over a support structure (e.g., a substrate, a die, a wafer, etc.), where a memory material is integrated with a transistor gate in that it is provided instead of, or in addition to, a conventional gate dielectric material that may be implemented in a transistor gate. The memory material may be used to store a bit value, or a memory state (e.g., logical "1" or "0") of the cell, thus implementing a memory element of the cell. The memory material may include one or more of the novel materials exhibiting FE or AFE behavior at thin dimensions (e.g., a thickness of the memory material may, in some embodiments, be between about 0.5 nanometers and 15 nanometers, including all values and ranges therein, e.g., between about 1 and 10 nanometers, or between about 1 and 5 nanometers). The transistor may be used as an access transistor to control access (e.g., access to write information to the cell or access to read information from the cell) to the memory element of the cell. The transistor may have a thin-film channel material, i.e., the transistor may be a thin-film transistor (TFT) (e.g., a thickness of the channel material may be comparable to that of the memory material). The channel material and the memory material are non-planar in that each includes a horizontal portion substantially parallel to the surface/plane of the support structure, and further includes a first and a second sidewall portions, each of which is substantially perpendicular to the surface/plane of the support structure, where the horizontal portion of the memory material is between the horizontal portion of the channel material and a gate electrode material of the transistor gate, the first sidewall portion of the memory material is between the first sidewall portion of the channel material and the gate electrode material, and the second sidewall portion of the memory material is between the second sidewall portion of the channel material and the gate electrode material. Memory cells with non-planar memory materials, described herein, may advantageously allow decreasing the Vc without substantially increasing the cell size or having to rely on engineering superior memory materials, and may be fabricated using relatively simple, low-cost fabrication processes. Other technical effects will be evident from various embodiments described here.

In the following detailed description, various aspects of the illustrative implementations may be described using terms commonly employed by those skilled in the art to convey the substance of their work to others skilled in the art. For example, the term "connected" means a direct electrical or magnetic connection between the things that are connected, without any intermediary devices, while the term "coupled" means either a direct electrical or magnetic connection between the things that are connected or an indirect connection through one or more passive or active intermediary devices. The term "circuit" means one or more passive and/or active components that are arranged to cooperate with one another to provide a desired function. As used herein, a "logic state" of a FE memory cell refers to one of a finite number of states that the cell can have, e.g., logic states "1" and "0," each state represented by a different polarization of the memory material of the cell. As used herein, a "READ" and "WRITE" memory access or operations refer to, respectively, determining/sensing a logic state of a memory cell and programming/setting a logic state of a memory cell. In various embodiments, the terms "oxide," "carbide," "nitride," etc. refer to compounds containing, respectively, oxygen, carbon, nitrogen, etc., while the term "high-k dielectric" refers to a material having a higher dielectric constant (k) than silicon oxide. The terms "substantially," "close," "approximately," "near," and "about," generally refer to being within +/-20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/-1-20%, e.g., within +/-1-10%, of a target value based on the context of a particular value as described herein or as known in the art.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer may be in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

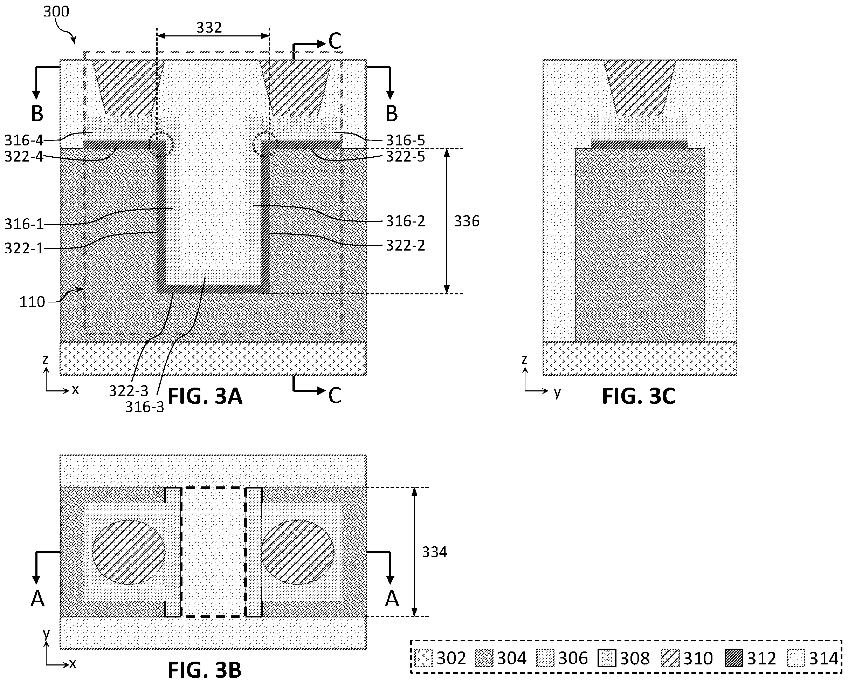

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 3A-3C, such a collection may be referred to herein without the letters, e.g., as "FIG. 3." In order to not clutter the drawings, sometimes only one instance of a given element is labeled in a drawing with a reference numeral, although other similar elements may be shown.

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Furthermore, although a certain number of a given element may be illustrated in some of the drawings (e.g., a certain number of memory cells in an IC device, a certain number of layers in a gate stack of a transistor, etc.), this is simply for ease of illustration, and more, or less, than that number may be included in the IC devices and related assemblies and packages according to various embodiments of the present disclosure. Still further, various views shown in some of the drawings are intended to show relative arrangements of various elements therein. In other embodiments, various IC devices and related assemblies and packages, or portions thereof, may include other elements or components that are not illustrated (e.g., various further components that may be in electrical contact with any of the illustrated components of the IC devices and related assemblies and packages, etc.). Inspection of layout and mask data and reverse engineering of parts of a device to reconstruct the circuit using e.g., optical microscopy, TEM, or SEM, and/or inspection of a cross-section of a device to detect the shape and the location of various device elements described herein using e.g., physical failure analysis (PFA) would allow determination of presence of one or more IC devices with memory cells with non-planar memory materials as described herein.

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

Various IC devices with memory cells with non-planar memory materials as described herein may be implemented in, or associated with, one or more components associated with an IC or/and may be implemented between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

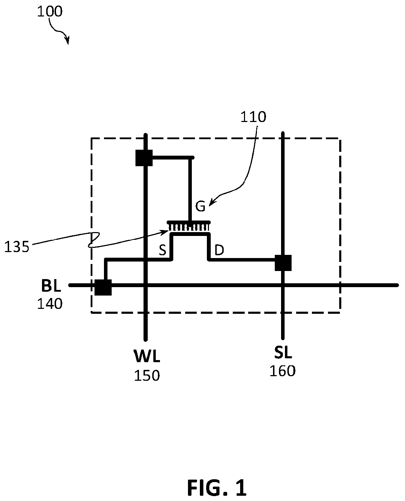

FIG. 1 is a schematic illustration (an electric circuit diagram) of a memory cell 100 in which a non-planar memory material is integrated with a transistor gate, according to some embodiments of the present disclosure. As shown in FIG. 1, the memory cell 100 may include a transistor 110 having a gate terminal, a source terminal, and a drain terminal, indicated in the example of FIG. 1 as terminals G, S, and D, respectively.

As is commonly known, the designation of source and drain terminals in a transistor may be interchangeable in certain implementations. Therefore, while the example of FIG. 1 illustrates a source terminal on the left side of the drawing and a drain terminal on the right side, in other embodiments, this arrangement may be reversed. Together, source and drain terminals of a transistor may be referred to a "transistor terminal pair," where the individual ones of these two terminals may be referred to as a "first source or drain (S/D) terminal" and a "second S/D terminal" (e.g., if the first S/D terminal is a source terminal, then the second S/D terminal is a drain terminal, and vice versa). The same applies to S/D regions of the transistor 110 (i.e., the designation of source and drain regions of a transistor may be interchangeable), where, in general, S/D regions of a transistor (also sometimes interchangeably referred to as "diffusion regions") are regions of doped semiconductors, e.g., regions of a doped channel material, so as to supply charge carriers for the transistor channel. Often, the S/D regions are highly doped, e.g., with dopant concentrations of about 1-1021 dopants per cubic centimeter (cm-3), in order to advantageously form Ohmic contacts with the respective S/D contacts (also sometimes interchangeably referred to as "S/D electrodes"), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the source region and the drain region), and, therefore, may be referred to as "highly doped" (HD) regions. The channel material of a transistor may include one or more semiconductor materials with doping concentrations significantly smaller than those of the S/D regions. For example, in some embodiments, the channel material may be an intrinsic (e.g., undoped) semiconductor material or alloy, not intentionally doped with any electrically active impurity. In alternate embodiments, one or more a nominal impurity dopant level may be present within the channel material, for example to set a threshold voltage Vt, or to provide HALO pocket implants, etc. In such impurity-doped embodiments however, impurity dopant level within the channel material are still significantly lower than in the S/D regions, for example below 1015 cm-3, or below 1013 cm-3. Depending on the context, the term "S/D terminal" may refer to a S/D region or a S/D contact or electrode of a transistor.

In various embodiments, the transistor 110 may be any FET, e.g., the transistor 110 may be either an N-type metal-oxide-semiconductor (NMOS) transistor or a P-type metal-oxide-semiconductor (PMOS) transistor. In particular, embodiments of the present disclosure are described with reference to the transistor 110 being a TFT. A TFT is a special kind of a FET made by depositing a thin film of an active semiconductor material, as well as a dielectric layer and conductive (e.g., metallic) contacts, over a supporting layer that may be a non-conductor layer and a non-semiconductor layer. At least a portion of the active semiconductor material forms a channel region/material of the TFT. This is different from conventional, non-TFT, frontend of line (FEOL) logic transistors where the semiconductor channel material of a transistor is typically a part of a semiconductor substrate, e.g., a part of a silicon wafer, or is epitaxially grown on a semiconductor substrate. Using TFTs as access transistors of memory cells provides several advantages and enables unique architectures that were not possible with conventional, FEOL logic transistors. For example, advantages include substantially lower leakage in TFTs than in logic transistors and lower temperature processing used to fabricate TFTs. In context of the present disclosure, the transistor 110 being a TFT advantageously allows depositing a thin-film channel material of the transistor 110 in a non-planar arrangement corresponding to the non-planar arrangement of the memory material of the memory cell 100, as will be described in greater detail below.

The transistor 110 is different from a conventional logic transistor in that, instead of or in addition to a gate dielectric material that may be included in the gate the transistor further includes a memory material 135 (schematically illustrated in FIG. 1 as short parallel vertical lines integrated with the notation of the gate of the transistor 110). In this manner, the memory material 135 of the memory cell 100 is integrated into the gate of the transistor 110.

As further shown in FIG. 1, in the memory cell 100, the gate terminal of the transistor 110 (e.g., a gate electrode material of the transistor 110) may be coupled to a word-line (WL) 150, one of the S/D terminals (e.g., a source terminal) of the transistor 110 may be coupled to a bit-line (BL) 140, and the other one of the S/D terminals (e.g., a drain terminal) of the transistor 110 may be coupled to a select-line (SL). As is known in the art, together, the WL 150, the BL 140, and the SL 160 may be used to read and program the bit state of the memory cell 100 by, respectively, sensing and setting the polarization of the memory material 135. Each of the WL 150, the BL 140, and the SL 160 may be made of the same or different electrically conductive materials, alloys, or stacks of multiple electrically conductive materials. In some embodiments, various electrically conductive materials that may be used to implement the WL 150, the BL 140, and the SL 160 may include one or more metals or metal alloys, with metals such as copper, ruthenium, palladium, platinum, cobalt, nickel, hafnium, zirconium, titanium, tantalum, and aluminum, and/or electrically conductive oxides or carbides of one or more metals.

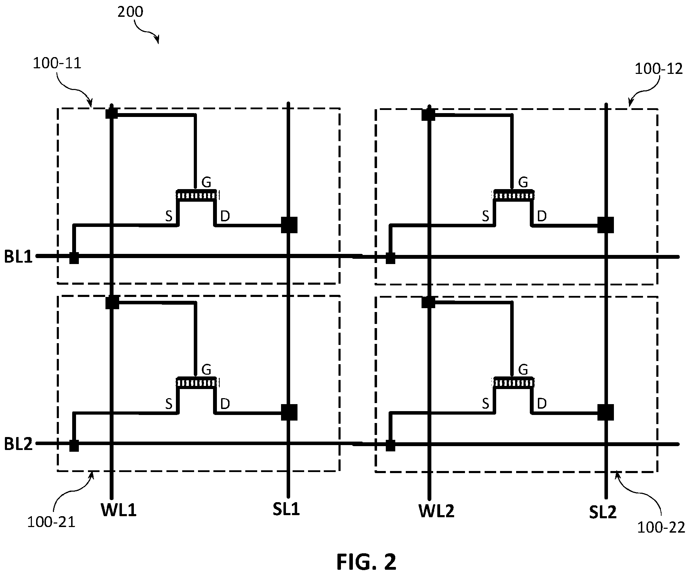

The memory cell 100 as shown in FIG. 1 is a "unit cell," where a plurality of such unit cells may be arranged in an array to implement a memory device. FIG. 2 provides a schematic illustration of a plurality of memory cells 100 of FIG. 1, namely four cells, arranged in an array 200, according to some embodiments of the present disclosure. Each memory cell shown in FIG. 2 could be any one of the memory cells having a non-planar memory material integrated with a transistor gate as described herein, e.g., any of the embodiments of the memory cell 100. Individual memory cells 100 are illustrated in FIG. 2 to be within one of the dashed boxes labeled 100-11, 100-12, 100-21, and 100-22. While only four memory cells 100 are shown in FIG. 2, in other embodiments, the array 200 may, and typically would, include many more memory cells. Furthermore, in other embodiments, the memory cells 100 may be arranged in arrays in a manner other than what is shown in FIG. 2, e.g., in any suitable manner of arranging memory cells into arrays as known in the art, all of which being within the scope of the present disclosure.

In some embodiments, each of the BL 140, the WL 150, and the SL 160 can be shared among multiple, possibly different subsets of, the memory cells 100 of a memory array. FIG. 2 illustrates one such embodiment where, as shown, the BL 140 can be shared among multiple memory cells 100 in a column, and each of the WL 150 and the SL 160 can be shared among multiple memory cells 100 in a row. As is conventionally used in context of memory, the terms "row" and "column" do not reflect the, respectively, horizontal and vertical orientation on a page of a drawing illustrating a memory array but, instead, reflect how individual memory cells are addressed. Namely, memory cells 100 sharing a single BL are said to be in the same column, while memory cells sharing a single WL are said to be on the same row. Thus, in FIG. 2, the horizontal lines refer to columns while vertical lines refer to rows. Different instances of each line (BL, WL, and FL) are indicated in FIG. 2 with different reference numerals, e.g., BL1 and BL2 are the two different instances of the BL 140 as described herein. The same reference numeral on the notation of different lines WL and SL shown in FIG. 2 indicates that those lines are used to address/control the memory cells in a single row, e.g., WL1 and SL1 are used to address/control the memory cells 100 in row 1, and so on. Each memory cell 100 may then be addressed by using the BL corresponding to the column of the cell and by using the WL and SL corresponding to the row of the cell. For example, as shown in FIG. 2, the memory cell 100-11 is controlled by BL1, WL1, and SL1, the memory cell 100-12 is controlled by BL1, WL2, and SL2, and so on.

While FIGS. 1 and 2 provide schematic illustrations where the memory cells 100 are shown using their electrical circuit representations, FIGS. 3-7 provide various views of IC devices that may implement such memory cells according to various embodiments of the present disclosure. A number of elements labeled in FIGS. 3-7 with reference numerals are indicated in FIGS. 3-7 with different patterns in order to not clutter the drawings with too many reference numerals, with a legend showing the correspondence between the reference numerals and patterns being provided at the bottom or on the side of FIGS. 3-7. For example, the legend illustrates that FIGS. 3-7 use different patterns to show a support structure 302, a gate electrode material 304, a channel material 306, S/D regions 308, S/D contacts 310, a memory material 312, and an insulator material 314, etc.

FIGS. 3A-3C provide various views of an example IC device 300 implementing a memory cell of FIG. 1 with a bottom-gated transistor 110 according to a first embodiment of the present disclosure. In particular, FIG. 3B illustrates the IC device 300 taken along the section B-B of FIG. 3A and FIG. 3C illustrates the IC device 300 taken along the section C-C of FIG. 3A, while FIG. 3A illustrates the IC device 300 taken along the section A-A of FIG. 3B. With reference to an example coordinate system x-y-z that may be used to provide different views of an IC device, FIGS. 3A and 3C provide cross-sectional side views across planes x-z and y-z, respectively, while FIG. 3B provides a top-down view across a plane x-y, with a number of components not shown in the top-down view of FIG. 3B to more readily illustrate how the gate of the transistor 110 of the IC device 300 may be arranged. Although FIG. 3A indicates that the cross-section C-C illustrated in FIG. 3C is taken through one of the S/D regions 308 on the right side of FIG. 3A, an analogous cross-section taken through the S/D region 308 on the left side of FIG. 3A may be identical, and thus the discussion of FIG. 3C refers generally to the "S/D region 308."

As shown in FIG. 3, the IC device 300 includes a support structure 302, over which the transistor 110 may be provided. In general, implementations of the present disclosure may be formed or carried out on a substrate, such as a semiconductor substrate composed of semiconductor material systems including, for example, N-type or P-type materials systems. In one implementation, the semiconductor substrate may be a crystalline substrate formed using a bulk silicon or a silicon-on-insulator substructure. In other implementations, the semiconductor substrate may be formed using alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-V, group II-VI, or group IV materials. Although a few examples of materials from which the substrate may be formed are described here, any material that may serve as a foundation upon which a semiconductor device may be built falls within the spirit and scope of the present disclosure. In various embodiments, the support structure 302 may include any such substrate that provides a suitable surface for providing the IC device with the memory cell 100.

A portion of the IC device 300 within a rectangular dashed contour shown in FIG. 3A indicates an approximate outline of the transistor 110. As shown in FIG. 3, the transistor 110 may include a gate electrode material 304, a channel material 306, and a pair of S/D regions 308 provided in the channel material 306, where S/D contacts 310 may contact respective S/D regions 308. As also shown in FIG. 3, a memory material 312 may be integrated with the gate of the transistor 110 by being provided between the gate electrode material 304 and the channel material 306. FIG. 3 further illustrates an insulator material 314 that may surround various portions of the transistor 110 to provide electrical isolation between portions of the IC device 300.

The gate electrode material 304 may include at least one P-type work function metal or N-type work function metal, depending on whether the transistor 110 is a PMOS transistor or an NMOS transistor (P-type work function metal used as a gate electrode material when the transistor 110 is a PMOS transistor and N-type work function metal used as a gate electrode material when the transistor 110 is an NMOS transistor). For a PMOS transistor, metals that may be used for the gate electrode material 304 may include, but are not limited to, ruthenium, palladium, platinum, cobalt, nickel, and conductive metal oxides (e.g., ruthenium oxide). For an NMOS transistor, metals that may be used for a gate electrode material 304 may include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, a gate electrode material 304 may include a stack of two or more metal layers, where one or more metal layers are work function metal layers and at least one metal layer is a fill metal layer. Further layers may be included next to a gate electrode material 304 for other purposes, such as to act as a diffusion barrier layer or/and an adhesion layer.

The channel material 306 may be composed of semiconductor material systems including, for example, N-type or P-type materials systems. In particular, the channel material 306 may be formed of a thin-film material. Some such materials may be deposited at relatively low temperatures, which allows depositing them within the thermal budgets imposed on back end fabrication to avoid damaging the frontend components (not specifically shown in FIG. 3) of the IC device 300. In some embodiments, the channel material 306 may have a thickness between about 1 and 75 nanometers, e.g., between about 1 nanometers and 10 nanometers or between about 5 nanometers and 30 nanometers, including all values and ranges therein. In some embodiments, the channel material 306 may include a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the channel material 306 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous, polymorphous, or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc.

Whether the channel material 306 is a thin-film channel material, as opposed to an epitaxially grown semiconductor material that may be included in the IC device by layer transfer, may be identified by inspecting grain size of the channel material 306. An average grain size of the channel material 306 being between about 0.5 and 1 millimeters (in which case the material may be considered to be polycrystalline) or smaller than about 0.5 millimeter (in which case the material may be considered to be polymorphous or amorphous) may be indicative of the channel material 306 being a thin-film material deposited onto portions of the IC device 300 and not epitaxially grown. On the other hand, an average grain size of the channel material 306 being equal to or greater than about 1 millimeter (in which case the material may be considered to be a single-crystalline material) may be indicative of the channel material 306 having been included in the IC device 300 by layer transfer. In the embodiments where the channel material 306 is a single-crystalline semiconductor material, it may include any of the materials described above that may be provided in a single-crystalline form.

As described above, S/D regions 308 may be regions of doped semiconductors, e.g., regions of a doped channel material, so as to supply charge carriers for the transistor channel. The S/D regions 308 may generally be formed using either an implantation/diffusion process or an etching/deposition process. In the former process, dopants such as boron, aluminum, antimony, phosphorous, or arsenic may be ion-implanted into the channel material to form the S/D regions 308 in the channel material 306. An annealing process that activates the dopants and causes them to diffuse further into the channel material 306 typically follows the ion implantation process. In the latter process, the channel material 306 may first be etched to form recesses at the locations of the S/D regions 308. An epitaxial deposition process may then be carried out to fill the recesses with material that is used to fabricate the S/D regions 308. In some implementations, the S/D regions 308 may be fabricated using a silicon alloy such as silicon germanium or silicon carbide. In some implementations the epitaxially deposited silicon alloy may be doped in situ with dopants such as boron, arsenic, or phosphorous. In further embodiments, the S/D regions 308 may be formed using one or more alternate semiconductor materials such as germanium or a group III-V material or alloy. And in further embodiments, one or more layers of metal and/or metal alloys may be used to form the S/D regions 308.

The S/D contacts 310 may include any suitable electrically conductive materials, or a combination of materials, such as any of the metallic materials described above with reference to the WL 150, the BL 140, and the SL 160. Although the S/D contacts 310 are illustrated in FIG. 3 as having trapezoidal cross-sections in an x-z plane of the reference coordinate system shown, which may be indicative of a subtractive deposition method that may be used to form them, in other embodiments, the S/D contacts 310 may have cross-sections that are substantially rectangular.

The memory material 312 is provided between the gate electrode material 304 and the channel material 306. The memory material 312 may include one or more materials which exhibit sufficient FE or AFE behavior even at thin dimensions as typically used in scaled transistors as the ones illustrated here. In some embodiments, the memory material 312 may include a material including hafnium, zirconium, and oxygen (e.g., hafnium zirconium oxide (HZO)), possibly doped with one or more dopants such as silicon, germanium, aluminum, yttrium, lanthanum, gadolinium, or niobium. In some embodiments, the memory material 312 may include a material including hafnium and oxygen (e.g., hafnium oxide), doped with one or more dopants. For example, the memory material 312 may include one or more of a material including silicon, hafnium, and oxygen (e.g., silicon-doped hafnium oxide), a material including germanium, hafnium, and oxygen (e.g., germanium-doped hafnium oxide), a material including aluminum, hafnium, and oxygen (e.g., aluminum-doped hafnium oxide), a material including yttrium, hafnium, and oxygen (e.g., yttrium-doped hafnium oxide), a material including lanthanum, hafnium, and oxygen (e.g., lanthanum-doped hafnium oxide), a material including gadolinium, hafnium, and oxygen (e.g., gadolinium-doped hafnium oxide), and a material including niobium, hafnium, and oxygen (e.g., niobium-doped hafnium oxide). However, in other embodiments, any other materials which exhibit FE or AFE behavior at thin dimensions may be used as the memory material 312 and are within the scope of the present disclosure. A layer of the memory material 312 may be a thin-film material and may have a thickness between about 0.5 nanometers and 15 nanometers, including all values and ranges therein (e.g., between about 1 and 10 nanometers, or between about 0.5 and 5 nanometers).

FIG. 3 and other similar drawings presented herein provide example illustrations of embodiments where the memory material 312 replaces a gate dielectric material conventionally provided in gate stacks of transistors. However, in other embodiments of the IC devices described herein, the transistor 110 may further include a gate dielectric material (not shown in the present drawings) in addition to the memory material 312, included, along with the gate electrode material 304, as a part of a gate stack of the transistor. In such embodiments, such a gate dielectric material may be included between at least a portion of the memory material 312 and at least a portion of the gate electrode material 304. In some embodiments, the gate dielectric material may include one or more high-k dielectric materials and may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric material of the IC device 300 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, scandium aluminum nitride, tantalum oxide, tantalum silicon oxide, lead scandium tantalum oxide, and lead zinc niobate. In some embodiments, an annealing process may be carried out on the gate dielectric material during manufacture of the IC device 300 to improve the quality of the gate dielectric. In some embodiments, the gate dielectric included in the gate stack of the transistor 110 may have a thickness between about 0.5 nanometers and 3 nanometers, including all values and ranges therein, e.g., between about 1 and 3 nanometers, or between about 1 and 2 nanometers.

Although also not shown in the present drawings, in some embodiments of the IC device 300, the transistor 110 may further include an intermediate material between at least a portion of the memory material 312 and at least a portion of the channel material 306. Such an intermediate material may include any non-conductive material, and may be provided to address endurance issues that may arise due to charging at the interface between the memory material 312 and the channel material 306 that may take place if the memory material 312 directly interfaces the channel material 306.

The insulator material 314 may include any suitable interlayer dielectric (ILD) material for providing electrical isolation between portions of the IC device 300. In various embodiments, the insulator material 314 may include materials such as silicon oxide, carbon-doped silicon oxide, silicon carbide, silicon nitride, silicon oxynitride, aluminum oxide, organic polymers such as perfluorocyclobutane or polytetrafluoroethylene, fluorosilicate glass (FSG), and organosilicates such as silsesquioxane, siloxane, or organosilicate glass. In some embodiments, the insulator material 314 may be a low-k dielectric. In some embodiments, the insulator material 314 may include pores or air gaps to further reduce its dielectric constant.

Turning to the details of the non-planar nature of the memory material 312, as shown in FIG. 3, each of the channel material 306 and the memory material 312 includes portions that may be referred to as "sidewall portions" because they are substantially perpendicular to the support structure 302, a portion that may be referred to as a "middle horizontal portion" because it is in between the sidewall portions (i.e., in the middle) and is substantially parallel to the support structure 302, and portions that may be referred to as "peripheral horizontal portions" because they are peripheral to the middle horizontal portion and are substantially horizontal to the support structure 302. The first and second sidewall portions of the channel material 306 are labeled in FIG. 3 as, respectively, portions 316-1 and 316-2, the middle horizontal portion of the channel material 306 is labeled in FIG. 3 as a portion 316-3, and the first and second peripheral horizontal portions of the channel material 306 are labeled in FIG. 3 as, respectively, portions 316-4 and 316-5. Similarly, the first and second sidewall portions of the memory material 312 are labeled in FIG. 3 as, respectively, portions 322-1 and 322-2, the middle horizontal portion of the memory material 312 is labeled in FIG. 3 as a portion 322-3, and the first and second peripheral horizontal portions of the memory material 312 are labeled in FIG. 3 as, respectively, portions 322-4 and 322-5. As shown in FIG. 3, the middle horizontal portion 322-3 is between the middle horizontal portion 316-3 and the gate electrode material 304, the first sidewall portion 322-1 is between the first sidewall portion 316-1 and the gate electrode material 304, and the second sidewall portion 322-2 is between the second sidewall portion 316-2 and the gate electrode material 304.

The different portions 316 of the channel material 306 form a continuous layer of the channel material 306, starting from the first peripheral horizontal portion 316-4, continuing with the first sidewall portion 316-1, then the middle horizontal portion 316-3, continuing with the second sidewall portion 316-2, and then the second peripheral horizontal portion 316-5. Thus, a continuous channel region is provided from the first S/D region 308 on the left side of FIG. 3A to the second S/D region 308 on the right side of FIG. 3A. Similarly, the different portions 322 of the memory material 312 form a continuous layer of the memory material 312, starting from the first peripheral horizontal portion 322-4, continuing with the first sidewall portion 322-1, then the middle horizontal portion 322-3, continuing with the second sidewall portion 322-2, and then the second peripheral horizontal portion 322-5. Thus, the memory material 312 is provided continuously along the channel material 306, between the channel material 306 and the gate electrode material 304, where the channel material 306 may be conformal to the shape of the memory material 312.

As shown in FIG. 3, the memory material 312 is non-planar in that it includes bends/corners. In particular, each of the memory material 312 and the channel material 306 of the IC device 300 may be seen as a U-shaped structure. The IC device 300 may then be described as having a gate that includes a U-shaped structure of the memory material 312. Because the channel material 306 is conformal to the shape of the memory material 312, the channel material 306 is non-planar as well and includes bends/corners corresponding to those of the memory material 312. In regions where the memory material 312 bends (i.e., at the corners of the memory material 312), e.g., in a region where the first peripheral horizontal portion 322-4 joins the first sidewall portion 322-1 and in a region where the second sidewall portion 322-2 joins the second peripheral horizontal portion 322-5 (indicated in FIG. 3A to be within dotted circular contours), the electric field is higher and, therefore, it may be easier to switch the polarization state of the memory material 312, thereby advantageously lowering the voltage Vc. Another advantage of the arrangement as shown in FIG. 3 is that, because the channel material 306 is conformal to the shape of the memory material 312, the effective gate length (Leff) of the transistor 110 may be increased without substantially increasing its footprint over the support structure 302. Increased effective gate length may help reduce device-to-device variations and decrease the current in the off-state (loff) of the transistor (i.e., leakage current). The effective gate length of the transistor 110 illustrated in FIG. 3 may be seen as a sum, or may be based on a sum, of the respective lengths of the portions 316-1, 316-3, and 316-2 of the channel material 306. Furthermore, the arrangement shown in FIG. 3 may enable trade off of area gain for larger contact resistance, which may yield better contact resistance and result in higher drive currents.

For the first embodiment illustrated in FIG. 3, the transistor 110 is a bottom-gated transistor. In other words, the gate electrode material 304 is provided in a first layer over the support structure 302, the first and second S/D regions 308 are provided in a second layer over the support structure 302, and the first layer is between the support structure 302 and the second layer.

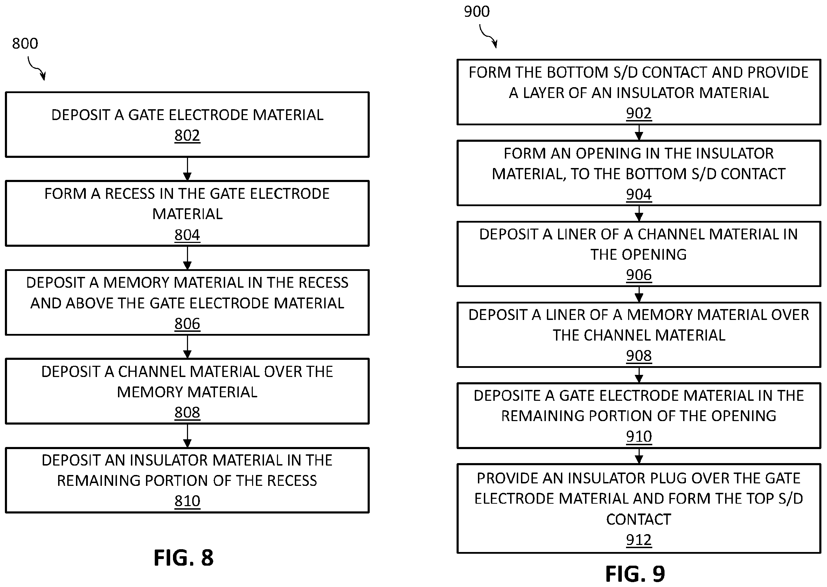

In some embodiments, the non-planar arrangement of the memory material 312 and the channel material 306 of the IC device 300 shown in FIG. 3 may be realized by a fabrication method 800, shown in FIG. 8.

The method 800 may include a process 802 in which the gate electrode material 304 is deposited over the support structure 302, and a process 804 in which a recess is formed in the gate electrode material 304 that was deposited in the process 804. A width of the recess formed in the process 804 may be a dimension of the recess between the first sidewall portion of the recess and the second sidewall portion of the recess (i.e., the width is a dimension measured substantially parallel to the support structure 302), shown in FIG. 3A as a width 332. A length of the recess formed in the process 804 may be a dimension of the recess that is perpendicular to the width 322 of the recess and substantially parallel to the support structure 302, shown in FIG. 3B as a length 334. A depth of the recess formed in the process 804 may be a dimension of the recess that is perpendicular to the support structure 302, shown in FIG. 3A as a depth 336. Thus, as defined herein, the width 332 of the recess refers to the dimension between portions of the gate electrode material 304 over which sidewall portions of the memory material 312 are to be provided, the length 334 of the recess refers to the distance between the opposite ends of the recess, where there are no sidewalls of the memory material 312 (for the embodiment of FIG. 3, the ends being in different x-z planes of the example coordinate system shown), and the depth 336 of the recess refers to the distance from the top of the gate electrode material 304 to the bottom of the recess. For the IC device 300 shown in FIG. 3, the width 332 is a dimension measured along the x-axis, the length 334 - along the y-axis, and the depth - along the z-axis of the example coordinate system shown in the present drawings.

The method 800 may further include a process 806 in which a liner of the memory material 312 is deposited in the recess and above the gate electrode material 304, and a process 808, following the process 806, in which a liner of the channel material 306 is deposited over the memory material 312 deposited in the process 806. Depositing a liner of a material into a recess or an opening means that the material is deposited on sidewalls and the bottom of the recess/opening, e.g., conformally. In this manner, the middle horizontal portion 322-3 of the memory material 312 may be at the bottom of the recess in the gate electrode material 304 (as shown in FIG. 3A), the first sidewall portion 322-1 of the memory material 312 may be at a first sidewall portion of the recess in the gate electrode material 304, the second sidewall portion 322-2 of the memory material 312 may be at a second sidewall portion of the recess in the gate electrode material 304, while the first and second peripheral horizontal portions 322-4 and 322-5 may be over, respectively, first and second portions of the top surface of the gate electrode material 304 on the opposite sides of the recess. Similarly, the middle horizontal portion 316-3 of the channel material 306 may be proximate the bottom of the recess, the first sidewall portion 316-1 may be proximate the first sidewall portion of the recess, the second sidewall portion 316-2 may be proximate the second sidewall portion of the recess, the first peripheral horizontal portion 316-4 may be proximate the first peripheral horizontal portion 322-4 on one side of the recess, and the second peripheral horizontal portion 316-5 may be proximate the first peripheral horizontal portion 322-5 on the other (opposite) side of the recess. In this manner, for the transistor 110 of the IC device 300, the first S/D region 308 is over a first portion of the top surface of the gate electrode material 304, while the second S/D region 308 is over a second portion of the top surface of the gate electrode material 304, i.e., the two S/D regions 308 are provided on opposite sides of the recess. The gate length of the transistor 110 of the IC device 300 may be based on a sum of the width 332 of the recess and two times of the depth 336 of the recess. For example, the gate length of the transistor 110 of the IC device 300 may be include a sum of the length of the first sidewall portion 316-1 of the channel material 306, the length of the middle horizontal portion 316-3 of the channel material 306, and the length of the second sidewall portion 316-2 of the channel material 306. The gate length of the transistor 110 of the IC device 300 may be substantially independent of the length 334 of the recess.

The method 800 may also include a process 810 in which the insulator material 314 may be deposited in the remaining portion of the recess (i.e., remaining after the sidewalls and bottom of the recess formed in the gate electrode material 304 have been lined with a layer of the memory material 312 and then a layer of the channel material 306).

In various embodiments, the processes 802, 806, 808, and 810 may include using any suitable deposition techniques such as atomic layer deposition (ALD), chemical vapor deposition (CVD), plasma enhanced CVD (PECVD), or physical vapor deposition (PVD) (e.g., evaporative deposition, magnetron sputtering, or e-beam deposition). In particular, the processes 806 and 808 may include using a conformal deposition technique such as ALD or CVD. On the other hand, the process 804 may include using any suitable etching techniques such as a dry etch, e.g., a radio frequency (RF) reactive ion etch (RIE) or inductively coupled plasma (ICP) RIE. In some embodiments, the etch performed in the process 804 may include an anisotropic etch, using etchants in a form of e.g., chemically active ionized gas (i.e., plasma) using e.g., bromine (Br) and chloride (CI) based chemistries. In some embodiments, during the etch of the process 804, the IC structure may be heated to elevated temperatures, e.g., to temperatures between about room temperature and 200 degrees Celsius, including all values and ranges therein, to promote that byproducts of the etch are made sufficiently volatile to be removed from the surface. In some embodiments, the etch performed in the process 804 may be a selective etch. As known in the art, two materials are said to have "sufficient etch selectivity" when etchants used to etch one material do not substantially etch the other, enabling selective etching of one material but not the other. The selective etch of the process 804 may be employed to remove portions of the gate electrode material 304 without substantially removing the surrounding insulator material 314 if the gate electrode material 304 is sufficiently etch selective with respect to the surrounding insulator material 314 (typically, conductive and insulating materials have good etch selectivity with respect to one another).

Any of the processes of the method 800 may be performed using any suitable patterning techniques, such as photolithographic or electron-beam (e-beam) patterning. Furthermore, the method 800 may include other operations not specifically shown in FIG. 8, such as various cleaning or planarization operations as known in the art. For example, in some embodiments, any layers of the IC device may be cleaned prior to, after, or during any of the processes of the method 800, e.g., to remove oxides, surface-bound organic and metallic contaminants, as well as subsurface contamination. In some embodiments, cleaning may be carried out using one or more of a chemical solution (such as peroxide), ultraviolet (UV) radiation combined with ozone, and oxidizing the surface (e.g., using thermal oxidation) followed by removing the oxide (e.g., using hydrofluoric acid (HF)). In another example, the IC devices as described herein may be planarized prior to, after, or during any of the processes of the method 800, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

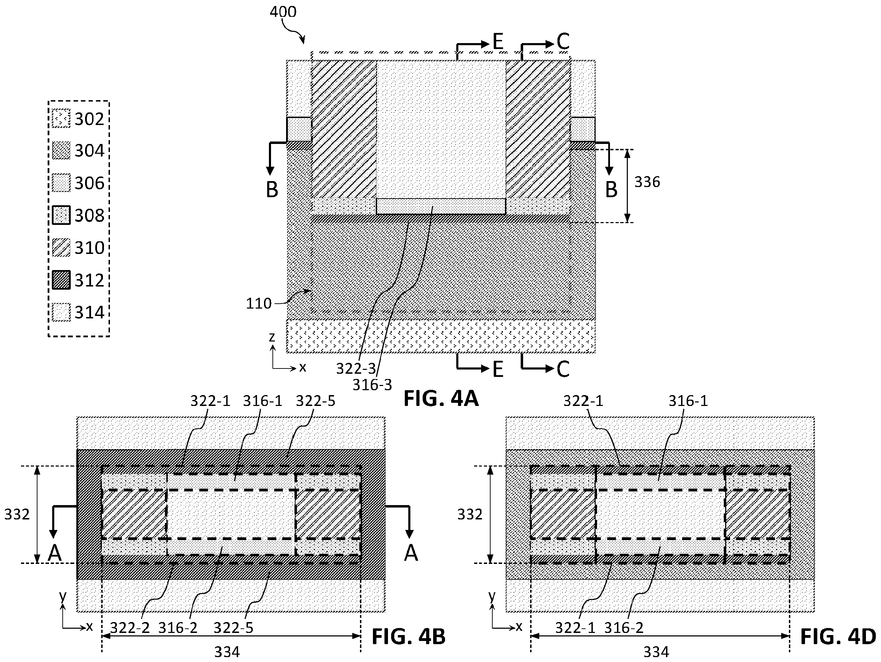

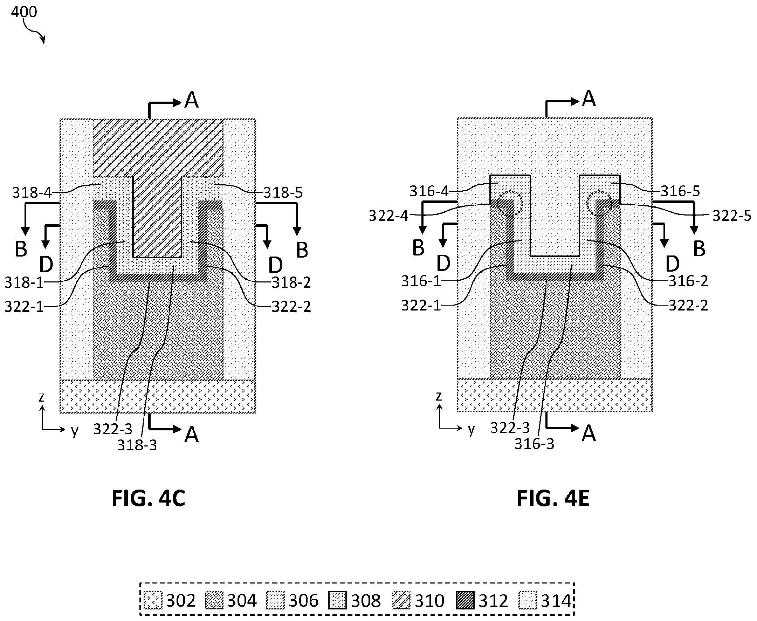

FIGS. 4A-4E provide various views of an example IC device 400 implementing a memory cell of FIG. 1 with a bottom-gated transistor 110 according to a first embodiment of the present disclosure. FIGS. 4A-4C are similar to respective ones of FIGS. 3A-3C in that FIG. 4B illustrates the IC device 400 taken along the section B-B of FIG. 4A (cross-section B-B also shown in FIG. 4C), FIG. 4C illustrates the IC device 400 taken along the section C-C of FIG. 4A, while FIG. 4A illustrates the IC device 400 taken along the section A-A of FIG. 4B (cross-section A-A also shown in FIG. 4B, FIG. 4C, and FIG. 4E). Furthermore, FIG. 4D illustrates the IC device 400 taken along the section D-D of FIG. 4C, and FIG. 4E illustrates the IC device 400 taken along the section E-E of FIG. 4A. With reference to an example coordinate system x-y-z that may be used to provide different views of an IC device, similar to FIG. 3, FIG. 4A provides a cross-sectional side view across a planes x-z, each of FIGS. 4C and 4E provide cross-sectional side views across different planes y-z, while FIGS. 4B and 4D provide top-down views across different planes x-y, with a number of components not shown in the top-down view of FIGS. 4B and 4D to more readily illustrate how the gate of the transistor 110 of the IC device 400 may be arranged.

The IC device 400 includes the support structure 302, the gate electrode material 304, the channel material 306, the S/D regions 308, the S/D contacts 310, the memory material 312, and the insulator material 314 as described with reference to FIG. 3. In the interests of brevity, descriptions of these elements are not repeated for the IC device 400 and only the differences from the IC device 300 are described. A portion of the IC device 400 within a rectangular dashed contour shown in FIG. 4A indicates an approximate outline of the transistor 110.

The transistors 110 of the IC device 400 is also a bottom-gated transistor, as the transistor 110 of the IC device 300. This means that for the transistor 110 of the IC device 400, the gate electrode material 304 is provided in a first layer over the support structure 302, the first and second S/D regions 308 are provided in a second layer over the support structure 302, and the first layer is between the support structure 302 and the second layer.

The differences in the IC devices 300 and 400 reside in the differences in the orientation of the recess in the gate electrode material 304 and, therefore, different locations of the sidewalls 316 of the channel material 306 and the sidewalls 322 of the memory material 312. In particular, if the width 332 and the length 334 of the recess are defined for the embodiment of FIG. 4 in the same manner as for the embodiment of FIG. 3 (i.e., the width 332 of the recess refers to the dimension between portions of the gate electrode material 304 over which sidewall portions of the memory material 312 are to be provided, and the length 334 of the recess refers to the distance between the opposite ends of the recess, where there are no sidewalls of the memory material 312), then the IC device 400 shown in FIG. 4, the width 332 is a dimension measured along the y-axis and the length 334 - along the x-axis of the example coordinate system shown in the present drawings (i.e., the recess of the IC device 400 extends perpendicularly to that of the IC device 300 and the opposite ends of the recess of the IC device 400 are in different y-z planes of the example coordinate system shown). As a result of this difference, in contrast to the transistor 110 of the IC device 300, the gate length of the transistor 110 of the IC device 400 may then be based on the length 334 of the recess in the gate electrode material 304 and may be substantially independent of the width 332 and the depth 336 of the recess. The depth 336 of the recess of the IC device 400 is still a dimension measured along the z-axis of the example coordinate system shown in the present drawings, the same as for the IC device 300.

The various portions 316 of the channel material 306 of the IC device 400 are defined in the same manner as for the IC device 300 and the various portions 322 of the memory material 312 of the IC device 400 are defined in the same manner as for the IC device 300, which descriptions are not repeated here. The difference between the IC device 400 and the IC device 300 resides in the orientation of the portions 316 and 322, resulting from the differences in the orientation of the recess, as described above. Furthermore, because of the differences in the orientation of the recess, in the IC device 400, each of the first and second S/D regions 308 also includes first and second sidewall portions, labeled in FIG. 4 as, respectively, portions 318-1 and 318-2, a middle horizontal portion 318-3, and first and second peripheral horizontal portions, labeled in FIG. 4 as, respectively, portions 318-4 and 318-5. As shown in FIG. 4, for each of the S/D regions 308 of the transistor 110 of the IC device 400, the middle horizontal portion 318-3 of the S/D region 308 is proximate to the middle horizontal portion 322-3 of the memory material 312 at the bottom of the recess, the first sidewall portion 318-1 of the S/D region 308 is proximate to the first sidewall portion 322-1 of the memory material 312 at the first sidewall portion of the recess, and the second sidewall portion 318-2 of the S/D region 308 is proximate to the second sidewall portion 322-2 of the memory material 312 at the second sidewall portion of the recess, the first peripheral horizontal portion 318-4 of the S/D region 308 is over a first portion of the top surface of the gate electrode material 304 (and over the first peripheral horizontal portion 322-4 of the memory material 312), and the peripheral horizontal portion 318-5 of the S/D region 308 is over a second portion of the top surface of the gate electrode material 304 (and over the second peripheral horizontal portion 322-5 of the memory material 312). Similar to the IC device 300, for the IC device 400, the first portion and the second portion of the top surface of the gate electrode material 304 are on opposite sides of the recess.

Also similar to the IC device 300, the memory material 312 of the IC device 400 is non-planar and in regions where the memory material 312 bends the electric field is higher and, therefore, it may be easier to switch the polarization state of the memory material 312, thereby advantageously lowering the voltage Vc. Examples of such regions are shown in FIG. 4E with dotted circular contours (i.e., a region where the first peripheral horizontal portion 322-4 joins the first sidewall portion 322-1 and in a region where the second sidewall portion 322-2 joins the second peripheral horizontal portion 322-5). Another advantage of the arrangement as shown in FIG. 4 is that the transistor 110 is wider because of the recess being oriented as shown in FIG. 4, and, therefore, it may support larger drive currents and, therefore, enable faster readout times.

Similar to the IC device 300, each of the memory material 312 and the channel material 306 of the IC device 400 may be seen as a U-shaped structure. The IC device 400 may then be described as having a gate that includes a U-shaped structure of the memory material 312. The difference between FIGS. 3 and 4 is that, for the IC device 300 of FIG. 3, the memory material 312 and the channel material 306 form the U-shaped structures when viewed as a cross-section of the transistor 110 along the source-channel-drain direction (i.e., cross-section of an x-z plane of the example coordinate system shown), while, for the IC device 400 of FIG. 4, the memory material 312 and the channel material 306 form the U-shaped structures when viewed as a cross-section of the transistor 110 perpendicular to the cross-section along the source-channel-drain direction (i.e., cross-section of an y-z plane of the example coordinate system shown).

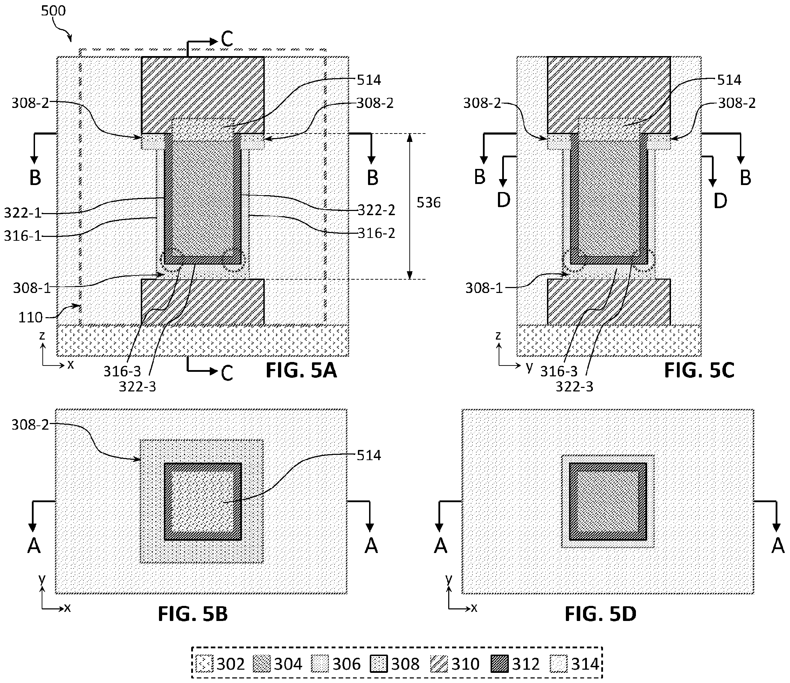

FIGS. 5A-5D provide various views of an example IC device 500 implementing a memory cell of FIG. 1 with a vertical transistor 110 according to a third embodiment of the present disclosure. FIGS. 5A-5D are similar to respective ones of FIGS. 4A-4D in that FIG. 5B illustrates the IC device 500 taken along the section B-B of FIG. 5A (cross-section B-B also shown in FIG. 5C), FIG. 5C illustrates the IC device 500 taken along the section C-C of FIG. 5A, FIG. 5A illustrates the IC device 500 taken along the section A-A of FIG. 5B (cross-section A-A also shown in FIG. 5B and FIG. 5D), and FIG. 5D illustrates the IC device 500 taken along the section D-D of FIG. 5C. With reference to an example coordinate system x-y-z that may be used to provide different views of an IC device, similar to FIG. 3 and FIG. 4, FIGS. 5A and 5C provide cross-sectional side views across planes x-z and y-z, respectively, while FIGS. 5B and 5D provide top-down views across different planes x-y, with a number of components not shown in the top-down view of FIGS. 5B and 5D to more readily illustrate how the gate of the transistor 110 of the IC device 500 may be arranged.

The IC device 500 includes the support structure 302, the gate electrode material 304, the channel material 306, the S/D regions 308, the S/D contacts 310, the memory material 312, and the insulator material 314 as described with reference to FIG. 3. In the interests of brevity, descriptions of these elements are not repeated for the IC device 500 and only the differences from the IC device 300 are described. A portion of the IC device 500 within a rectangular dashed contour shown in FIG. 5A indicates an approximate outline of the transistor 110.

The transistors 110 of the IC device 500 is a vertical transistor, which is different from the transistor 110 of the IC device 300 and the transistor 110 of the IC device 400, each of which was a bottom-gated transistor. This means that for the transistor 110 of the IC device 500, the first S/D region 308-1 is in a first layer over the support structure 302, the gate electrode material 304 is in a second layer over the support structure 302, the second S/D region 308-2 is in a third layer over the support structure 302, where the first layer is between the support structure 302 and the second layer, and the second layer is between the first layer and the third layer.

Similar to the transistors 110 of the IC devices 300 and 400, sidewall portions 316-1 and 316-2, and middle horizontal portion 316-3 of the channel material 306 may be defined for the transistor 110 of the IC devices 500. Further similar to the transistors 110 of the IC devices 300 and 400, sidewall portions 322-1 and 322-2, and middle horizontal portion 322-3 of the memory material 312 may also be defined for the transistor 110 of the IC devices 500. As shown in FIG. 5, and similar to the IC devices of FIGS. 3 and 4, for the IC device 500, the middle horizontal portion 322-3 is between the middle horizontal portion 316-3 and the gate electrode material 304, the first sidewall portion 322-1 is between the first sidewall portion 316-1 and the gate electrode material 304, and the second sidewall portion 322-2 is between the second sidewall portion 316-2 and the gate electrode material 304.

The transistor 110 of the IC device 500 may be formed based on an opening in the insulator material 314. In some embodiments, the non-planar arrangement of the memory material 312 and the channel material 306 of the IC device 500 shown in FIG. 5 may be realized by a fabrication method 900, shown in FIG. 9.

The method 900 may include a process 902 in which the bottom S/D contact 310 is formed and then a layer of the insulator material 314 is deposited over it, and a process 904 in which an opening is formed in the insulator material 314 over the bottom S/D contact 310, the opening reaching to (i.e., stopping at) the bottom S/D contact 310. A depth of the opening formed in the process 904 may be a dimension of the opening that is perpendicular to the support structure 302, shown in FIG. 5A as a depth 536. The top-down views of FIGS. 5B and 5D illustrate the opening formed in the process 904 as having a transverse cross-section that is substantially rectangular opening, however, in other embodiments, the opening may be substantially circular instead, or may have any other shape.

The method 900 may further include a process 906 in which a liner of the channel material 306 is deposited in the opening and above the bottom S/D contact 310 formed in the process 902, and a process 908, following the process 906, in which a liner of the memory material 312 is deposited in the opening, over the channel material 312 deposited in the process 906. In this manner, the middle horizontal portion 316-3 of the channel material 306 may be at the bottom of the opening (as shown in FIG. 5A), the first sidewall portion 316-1 of the channel material 306 may be at a first sidewall portion of the opening in the insulator material 314, and the second sidewall portion 316-2 of the channel material 306 may be at a second sidewall portion of the opening in the insulator material 314. Thus, for the IC device 500, the first sidewall portion 316-1 of the channel material 306 is between the insulator material 314 and the first sidewall portion 322-1 of the memory material 312, and the second sidewall portion 316-2 of the channel material 306 is between the insulator material 314 and the second sidewall portion 322-2 of the memory material 312.

The method 900 may also include a process 910 in which the gate electrode material 304 may be deposited in the remaining portion of the opening (i.e., remaining after the sidewalls and bottom of the opening formed in the insulator material 314 have been lined with a layer of the channel material 306 and then a layer of the memory material 312). In this manner, the gate electrode material 304 may be nested within the opening above the bottom S/D contact 310. The method 900 may further include a process 912 in which an insulator plug of an additional insulator material 514 is provided over the gate electrode material 304 and then the top S/D contact 310 is formed. The additional insulator material 514 may be provided in the IC device 500 to electrically isolate the gate electrode material 304 and the top S/D contacts 310 (i.e., the S/D contact 310 to the second S/D region 308-2, as shown in FIG. 5). The additional insulator material 514 may include any of the materials described with reference to the insulator material 314. For the arrangement shown in FIG. 5, the gate length of the transistor 110 may be based on the depth 536 and may be substantially independent of other dimensions of the opening.

In various embodiments, the processes 902, 906, 908, 910, and 912 may include using any suitable deposition techniques such as any of those described above. In particular, the processes 906 and 908 may include using a conformal deposition technique such as ALD or CVD. On the other hand, the process 904 may include using any suitable etching techniques such as any of those described above. In some embodiments, the etch of the process 904 may be etch selective using etchants that can remove portions of the insulator material 314 without substantially etching into the bottom S/D contact 310 (this is similar to the etch selective process that may be employed in the process 804, except with reversed etch selectivity).

Similar to the method 800, any of the processes of the method 900 may be performed using any suitable patterning techniques and/or the method 900 may include other operations not specifically shown in FIG. 9, such as various cleaning or planarization operations as known in the art. Furthermore, although the operations of the method 800 and the method 900 are illustrated once each and in a particular order, the operations may be performed in any suitable order and repeated as desired. For example, one or more operations may be performed in parallel e.g., to manufacture multiple memory cells substantially simultaneously. In another example, the operations may be performed in a different order to reflect the structure of a memory device in which the memory cell will be included. In yet another example, some operations may be combined into a single operation, and some operations may be subdivided into more operations than what is shown in FIGS. 8 and 9.

Similar to the IC devices 300 and 400, the memory material 312 of the IC device 500 is non-planar and in regions where the memory material 312 bends the electric field is higher and, therefore, it may be easier to switch the polarization state of the memory material 312, thereby advantageously lowering the voltage Vc. Examples of such regions are shown in FIGS. 5A and 5C with dotted circular contours (i.e., a region where the first sidewall portion 322-1 joins the middle horizontal portion 322-3 and in a region where the middle horizontal portion 322-3 joins the second sidewall portion 322-2). Other advantages of the arrangement as shown in FIG. 5 may include the ability to use the arrangement to scale down for embedded dynamic random access memory (DRAM), improvements in shorting margin, the ability to tune the capacitance between the gate electrode material 304 and the S/D contact 310 to the second S/D region 308-2 by changing the thickness of the additional insulator material 514, improvements in contact resistance by increasing the current injection area over conventional vertical transistor structures, and independent treatment of S/D regions.

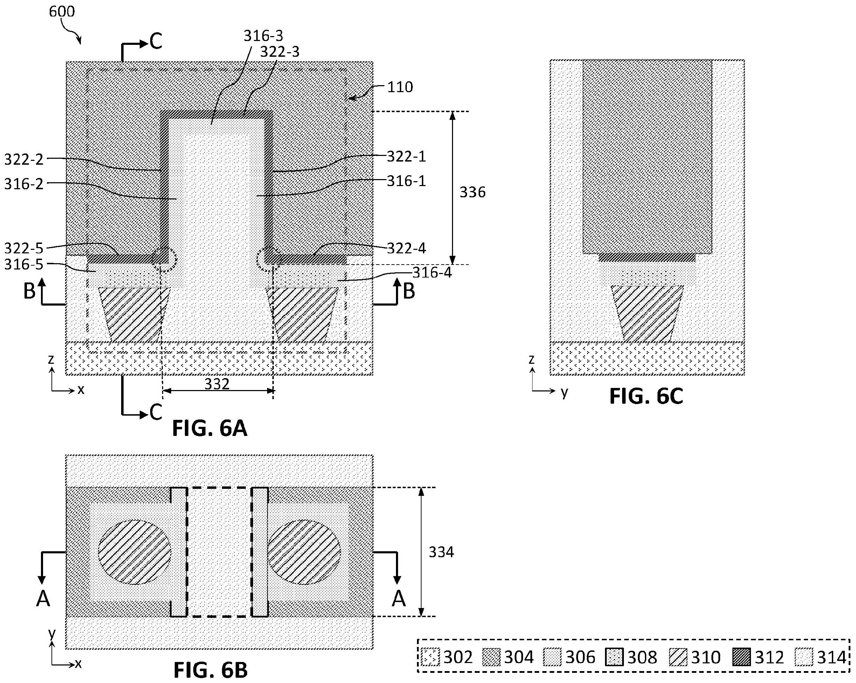

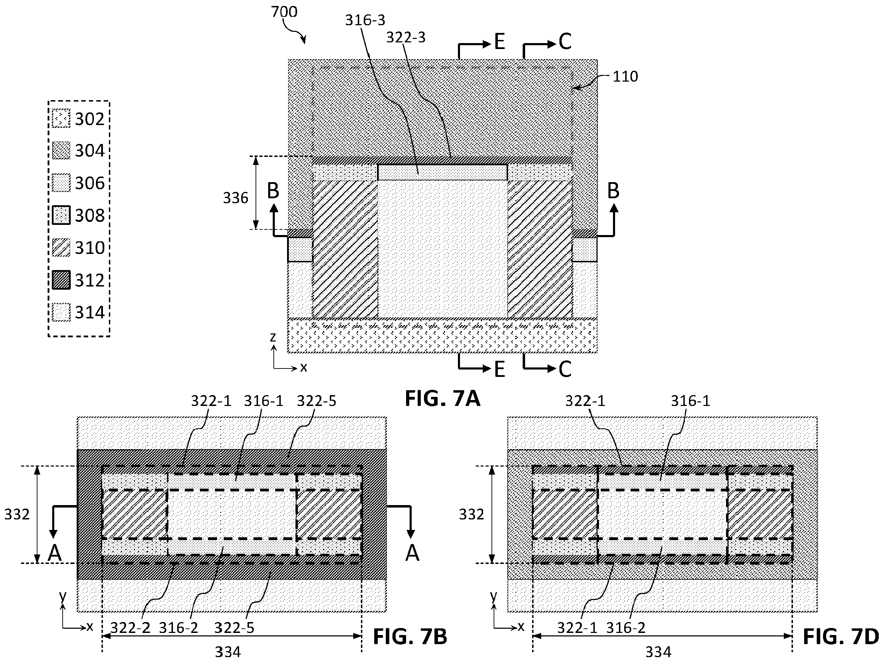

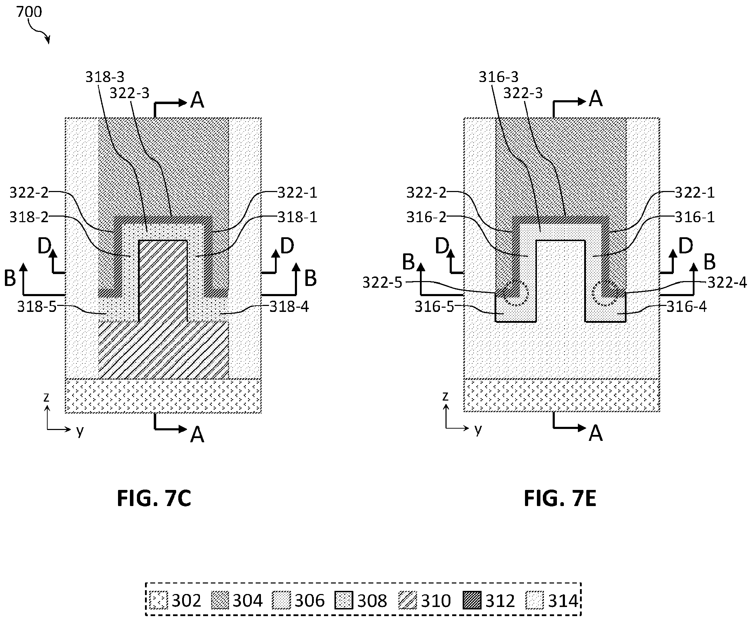

While the arrangements of FIGS. 3 and 4 were shown for bottom-gated transistors, analogous memory cells with non-planar memory materials may be implemented using top-gated transistors, as shown in FIGS. 6 and 7, respectively.

FIGS. 6A-6C provide various views of an example IC device 600 implementing a memory cell 100 of FIG. 1 with a top-gated transistor 110 according to a fourth embodiment of the present disclosure. The views of FIGS. 6A-6C are analogous to the respective ones of FIGS. 3A-3C. The transistor 110 of the IC device 600 is substantially the same as the transistor 110 of the IC device 300, except that it is provided over the support structure 302 upside-down, compared to the transistor 110 of the IC device 300, resulting in the differences in the views of FIGS. 6A and 6C compared to those of FIGS. 3A and 3C (the view of FIG. 6B may be substantially the same as that of FIG. 3B). What is not illustrated upside-down in FIG. 6 are the trapezoidal cross-sections of the S/D contacts 310 illustrated in FIG. 6, those are oriented in the same way as the trapezoidal cross-sections of the S/D contacts 310 illustrated in FIG. 3, which may be indicative of a subtractive deposition method that may be used to form them. Other descriptions provided with respect to FIG. 3 are applicable to FIG. 6 with consideration of the differences described above, and, therefore, in the interests of brevity, are not repeated.

As a result of the transistor of the IC device 600 being arranged upside-down compared to that of the IC device 300, the order of the processes for fabricating it would be different from that of the method 800 and the non-planar arrangement of the memory material 312 would be realized not by using a recess as described with respect to the IC device 300 but using an analogous structure of the insulator material 314 extending away from the support structure, above the S/D contacts 310. The descriptions provided herein make it clear for a person of ordinary skill in the art how to modify the processes of the method 800 to arrive at the arrangement of the IC device 600 as shown in FIG. 6. Therefore, all fabrication methods for providing the IC device 600 as shown in FIG. 6 are within the scope of the present disclosure.

FIGS. 7A-7E provide various views of an example IC device 700 implementing a memory cell 100 of FIG. 1 with a top-gated transistor 110 according to a fifth embodiment of the present disclosure. The views of FIGS. 7A-7E are analogous to the respective ones of FIGS. 4A-4E. The transistor 110 of the IC device 700 is substantially the same as the transistor 110 of the IC device 400, except that it is provided over the support structure 302 upside-down, compared to the transistor 110 of the IC device 400, resulting in the differences in the views of FIGS. 7A, 7C, and 7E compared to those of, respectively, FIGS. 4A, 4C, and 4E (the view of FIG. 7B may be substantially the same as that of FIG. 4B and the view of FIG. 7D may be substantially the same as that of FIG. 4D). Other descriptions provided with respect to FIG. 4 are applicable to FIG. 7 with consideration of the differences described above, and, therefore, in the interests of brevity, are not repeated.

As a result of the transistor of the IC device 700 being arranged upside-down compared to that of the IC device 400, the order of the processes for fabricating it would be different from that of the method 800 and the non-planar arrangement of the memory material 312 would be realized not by using a recess as described with respect to the IC device 300 but using an analogous structure of the insulator material 314 extending away from the support structure 302. The descriptions provided herein make it clear for a person of ordinary skill in the art how to modify the processes of the method 800 to arrive at the arrangement of the IC device 700 as shown in FIG. 7. Therefore, all fabrication methods for providing the IC device 700 as shown in FIG. 7 are within the scope of the present disclosure.

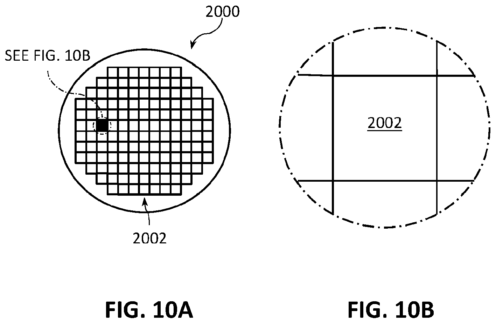

Memory cells with non-planar memory materials as disclosed herein may be included in any suitable electronic device. FIGS. 10-14 illustrate various examples of devices and components that may include one or more memory cells with non-planar memory materials as disclosed herein.

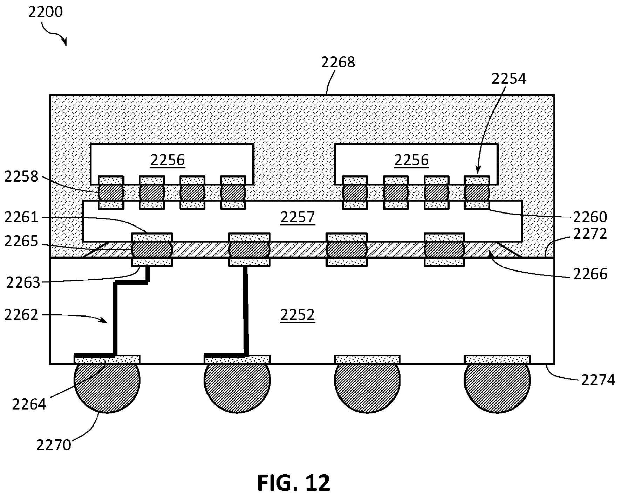

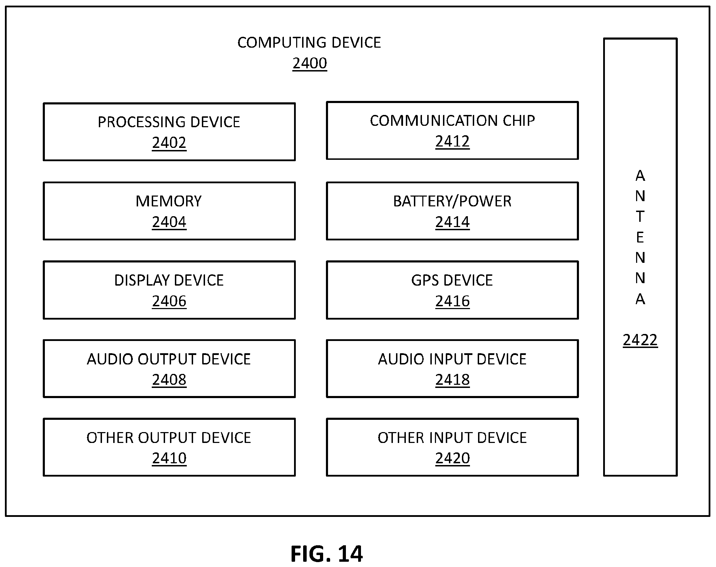

FIGS. 10A-10B are top views of a wafer 2000 and dies 2002 that may include one or more memory cells with non-planar memory materials in accordance with any of the embodiments disclosed herein. In some embodiments, the dies 2002 may be included in an IC package, in accordance with any of the embodiments disclosed herein. For example, any of the dies 2002 may serve as any of the dies 2256 in an IC package 2200 shown in FIG. 12. The wafer 2000 may be composed of semiconductor material and may include one or more dies 2002 having IC structures formed on a surface of the wafer 2000. Each of the dies 2002 may be a repeating unit of a semiconductor product that includes any suitable IC (e.g., ICs including one or more memory cells with non-planar memory materials as described herein). After the fabrication of the semiconductor product is complete (e.g., after manufacture of one or more memory cells with non-planar memory materials as described herein), the wafer 2000 may undergo a singulation process in which each of the dies 2002 is separated from one another to provide discrete "chips" of the semiconductor product. In particular, devices that include one or more memory cells with non-planar memory materials as disclosed herein may take the form of the wafer 2000 (e.g., not singulated) or the form of the die 2002 (e.g., singulated). The die 2002 may include one or more transistors (e.g., one or more transistors 110 having non-planar memory materials 312 integrated with transistor gates as described herein and/or one or more of conventional logic transistors, discussed below) and/or supporting circuitry to route electrical signals to the transistors, as well as any other IC components. In some embodiments, the wafer 2000 or the die 2002 may include a memory device (e.g., a static random access memory (SRAM) device), a logic device (e.g., an AND, OR, NAND, or NOR gate), or any other suitable circuit element. In some embodiments, the wafer 2000 or the die 2002 may include a memory device with a plurality of memory cells with non-planar memory materials, as described herein. Multiple ones of these devices may be combined on a single die 2002. For example, a memory array formed by multiple memory devices, e.g., formed by multiple memory cells with non-planar memory materials as described herein, may be formed on a same die 2002 as a processing device (e.g., the processing device 2402 of FIG. 14) or other logic that is configured to store information in the memory devices or execute instructions stored in the memory array.

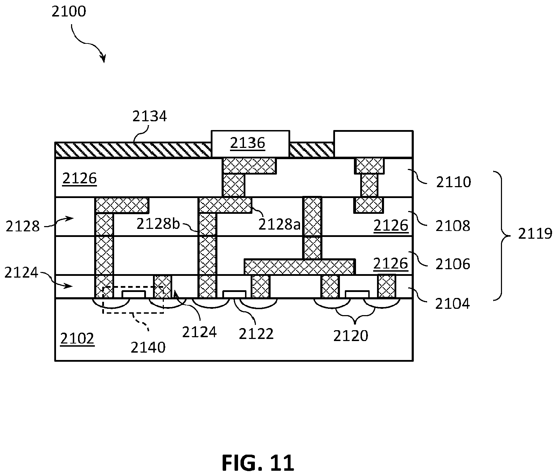

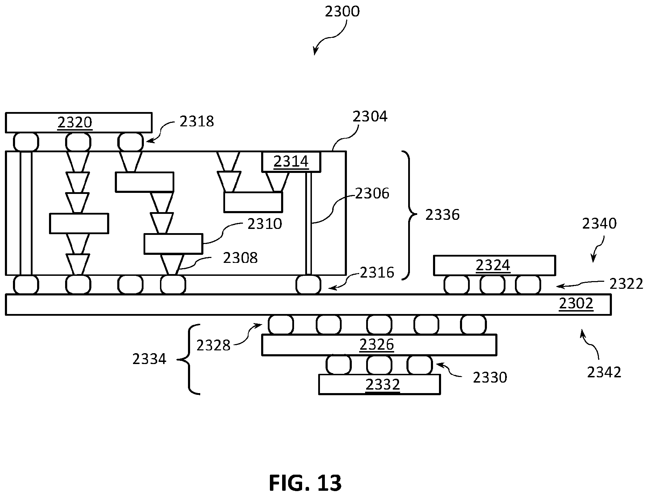

FIG. 11 is a cross-sectional side view of an IC device 2100 that may include one or more memory cells with non-planar memory materials in accordance with any of the embodiments disclosed herein. In some embodiments, the IC device 2100 may serve as any of the dies 2256 in the IC package 2300 shown in FIG. 13.

As shown in FIG. 11, the IC device 2100 may be formed on a substrate 2102 (e.g., the wafer 2000 of FIG. 10A) and may be included in a die (e.g., the die 2002 of FIG. 10B). The substrate 2102 may include any material that may serve as a foundation for an IC device 2100. The substrate 2102 may be a semiconductor substrate and may be implemented as any of the examples provided above with reference to the support structure 302. The substrate 2102 may be part of a singulated die (e.g., the die 2002 of FIG. 10B) or a wafer (e.g., the wafer 2000 of FIG. 10A).

The IC device 2100 may include one or more device layers 2104 disposed on the substrate 2102. The device layer 2104 may include features of one or more transistors 2140 (e.g., MOSFETs) formed on the substrate 2102. The device layer 2104 may include, for example, one or more S/D regions 2120, a gate 2122 to control current flow in the transistors 2140 between the S/D regions 2120, and one or more S/D contacts 2124 to route electrical signals to/from the S/D regions 2120. The transistors 2140 may include additional features not depicted for the sake of clarity, such as device isolation regions, gate contacts, and the like.

Each transistor 2140 may include a gate 2122 formed of at least two layers, a gate dielectric layer and a gate electrode layer. Generally, the gate dielectric layer of a transistor 2140 may include one layer or a stack of layers, and may include any of the materials described above with reference to the gate dielectric that may be included in the gate stack of the transistor 110 of the IC device 300. In some embodiments, an annealing process may be carried out on the gate dielectric of the gate 2122 to improve its quality when a high-k material is used.

The gate electrode may be formed on the gate dielectric and may include at least one P-type work function metal or N-type work function metal, depending on whether the transistor 2140 is to be a PMOS or an NMOS transistor. In some implementations, the gate electrode may include a stack of two or more metal layers, where one or more metal layers are work function metal layers and at least one metal layer is a fill metal layer. Further metal layers may be included for other purposes, such as a barrier layer. The gate electrode of the gate 2122 may include any of the materials described above with reference to the gate electrode material 304.

In some embodiments, when viewed as a cross-section of the transistor 2140 along the source-channel-drain direction, the gate electrode of the gate 2122 may include a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may include a combination of U-shaped structures and planar, non-U-shaped structures. For example, the gate electrode may include one or more U-shaped metal layers formed atop one or more planar, non-U-shaped layers. In some embodiments, the gate electrode may include a V-shaped structure (e.g., when a fin of a fin-FET does not have a "flat" upper surface, but instead has a rounded peak).

In some embodiments, a pair of sidewall spacers may be formed on opposing sides of the gate stack to bracket the gate stack. The sidewall spacers may be formed from a material such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 2120 may be formed within the substrate 2102, e.g., adjacent to the gate of each transistor 2140. The S/D regions 2120 may be formed using an implantation/diffusion process or an etching/deposition process, for example, as was described above with reference to the S/D regions 308. In the former process, dopants such as boron, aluminum, antimony, phosphorous, or arsenic may be ion-implanted into the substrate 2102 to form the S/D regions 2120. An annealing process that activates the dopants and causes them to diffuse farther into the substrate 2102 may follow the ion implantation process. In the latter process, the substrate 2102 may first be etched to form recesses at the locations of the S/D regions 2120. An epitaxial deposition process may then be carried out to fill the recesses with material that is used to fabricate the S/D regions 2120. In some implementations, the S/D regions 2120 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 2120 may be formed using one or more alternate semiconductor materials such as germanium or a group III-V material or alloy. In further embodiments, one or more layers of metal and/or metal alloys may be used to form the S/D regions 2120.

Various transistors 2140 are not limited to the type and configuration depicted in FIG. 11 and may include a wide variety of other types and configurations such as, for example, planar transistors, non-planar transistors, or a combination of both. Furthermore, any of the transistors 2140 may be implemented as, or replaced with, transistors 110 having non-planar memory materials 312 integrated with its gates as described herein, e.g., any of the transistors 2140 may be implemented as, or replaced with, the memory cells 100 as described herein.

Electrical signals, such as power and/or input/output (I/O) signals, may be routed to and/or from the transistors 2140 of the device layer 2104 through one or more interconnect layers disposed on the device layer 2104 (illustrated in FIG. 11 as interconnect layers 2106-2110). For example, electrically conductive features of the device layer 2104 (e.g., the gate 2122 and the S/D contacts 2124) may be electrically coupled with the interconnect structures 2128 of the interconnect layers 2106-2110. The one or more interconnect layers 2106-2110 may form an ILD stack 2119 of the IC device 2100.

The interconnect structures 2128 may be arranged within the interconnect layers 2106-1210 to route electrical signals according to a wide variety of designs (in particular, the arrangement is not limited to the particular configuration of interconnect structures 2128 depicted in FIG. 11). Although a particular number of interconnect layers 2106-1210 is depicted in FIG. 11, embodiments of the present disclosure include IC devices having more or fewer interconnect layers than depicted.

In some embodiments, the interconnect structures 2128 may include trench structures 2128a (sometimes referred to as "lines" or "traces") and/or via structures 2128b (sometimes referred to as "holes") filled with an electrically conductive material such as a metal. The trench structures 2128a may be arranged to route electrical signals in a direction of a plane that is substantially parallel with a surface of the substrate 2102 upon which the device layer 2104 is formed. For example, the trench structures 2128a may route electrical signals in a direction in and out of the page from the perspective of FIG. 11. The via structures 2128b may be arranged to route electrical signals in a direction of a plane that is substantially perpendicular to the surface of the substrate 2102 upon which the device layer 2104 is formed. In some embodiments, the via structures 2128b may electrically couple trench structures 2128a of different interconnect layers 2106-2110 together.

The interconnect layers 2106-2110 may include a dielectric material 2126 disposed between the interconnect structures 2128, as shown in FIG. 11. In some embodiments, the dielectric material 2126 disposed between the interconnect structures 2128 in different ones of the interconnect layers 2106-2110 may have different compositions; in other embodiments, the composition of the dielectric material 2126 between different interconnect layers 2106-2110 may be the same.

A first interconnect layer 2106 (referred to as Metal 1 or "M1") may be formed directly on the device layer 2104. In some embodiments, the first interconnect layer 2106 may include trench structures 2128a and/or via structures 2128b, as shown. The trench structures 2128a of the first interconnect layer 2106 may be coupled with contacts (e.g., the S/D contacts 2124) of the device layer 2104.

A second interconnect layer 2108 (referred to as Metal 2 or "M2") may be formed directly on the first interconnect layer 2106. In some embodiments, the second interconnect layer 2108 may include via structures 2128b to couple the trench structures 2128a of the second interconnect layer 2108 with the trench structures 2128a of the first interconnect layer 2106. Although the trench structures 2128a and the via structures 2128b are structurally delineated with a line within each interconnect layer (e.g., within the second interconnect layer 2108) for the sake of clarity, the trench structures 2128a and the via structures 2128b may be structurally and/or materially contiguous (e.g., simultaneously filled during a dual-damascene process) in some embodiments.

A third interconnect layer 2110 (referred to as Metal 3 or "M3") (and additional interconnect layers, as desired) may be formed in succession on the second interconnect layer 2108 according to similar techniques and configurations described in connection with the second interconnect layer 2108 or the first interconnect layer 2106.

The IC device 2100 may include a solder resist material 2134 (e.g., polyimide or similar material) and one or more bond pads 2136 formed on the interconnect layers 2106-2110. The bond pads 2136 may be electrically coupled with the interconnect structures 2128 and configured to route the electrical signals of the transistor(s) 2140 to other external devices. For example, solder bonds may be formed on the one or more bond pads 2136 to mechanically and/or electrically couple a chip including the IC device 2100 with another component (e.g., a circuit board). The IC device 2100 may have other alternative configurations to route the electrical signals from the interconnect layers 2106-2110 than depicted in other embodiments. For example, the bond pads 2136 may be replaced by or may further include other analogous features (e.g., posts) that route the electrical signals to external components.

FIG. 12 is a side, cross-sectional view of an example IC package 2200 that may include one or more memory cells with non-planar memory materials in accordance with any of the embodiments disclosed herein. In some embodiments, the IC package 2200 may be a system-in-package (SiP).

The package substrate 2252 may be formed of a dielectric material (e.g., a ceramic, a buildup film, an epoxy film having filler particles therein, etc.), and may have conductive pathways extending through the dielectric material between the face 2272 and the face 2274, or between different locations on the face 2272, and/or between different locations on the face 2274. These conductive pathways may take the form of any of the interconnect structures 2128 discussed above with reference to FIG. 11.

The package substrate 2252 may include conductive contacts 2263 that are coupled to conductive pathways 2262 through the package substrate 2252, allowing circuitry within the dies 2256 and/or the interposer 2257 to electrically couple to various ones of the conductive contacts 2264 (or to other devices included in the package substrate 2252, not shown).

The IC package 2200 may include an interposer 2257 coupled to the package substrate 2252 via conductive contacts 2261 of the interposer 2257, first-level interconnects 2265, and the conductive contacts 2263 of the package substrate 2252. The first-level interconnects 2265 illustrated in FIG. 12 are solder bumps, but any suitable first-level interconnects 2265 may be used. In some embodiments, no interposer 2257 may be included in the IC package 2200; instead, the dies 2256 may be coupled directly to the conductive contacts 2263 at the face 2272 by first-level interconnects 2265.

The IC package 2200 may include one or more dies 2256 coupled to the interposer 2257 via conductive contacts 2254 of the dies 2256, first-level interconnects 2258, and conductive contacts 2260 of the interposer 2257. The conductive contacts 2260 may be coupled to conductive pathways (not shown) through the interposer 2257, allowing circuitry within the dies 2256 to electrically couple to various ones of the conductive contacts 2261 (or to other devices included in the interposer 2257, not shown). The first-level interconnects 2258 illustrated in FIG. 12 are solder bumps, but any suitable first-level interconnects 2258 may be used. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

In some embodiments, an underfill material 2266 may be disposed between the package substrate 2252 and the interposer 2257 around the first-level interconnects 2265, and a mold compound 2268 may be disposed around the dies 2256 and the interposer 2257 and in contact with the package substrate 2252. In some embodiments, the underfill material 2266 may be the same as the mold compound 2268. Example materials that may be used for the underfill material 2266 and the mold compound 2268 are epoxy mold materials, as suitable. Second-level interconnects 2270 may be coupled to the conductive contacts 2264. The second-level interconnects 2270 illustrated in FIG. 12 are solder balls (e.g., for a ball grid array arrangement), but any suitable second-level interconnects 22770 may be used (e.g., pins in a pin grid array arrangement or lands in a land grid array arrangement). The second-level interconnects 2270 may be used to couple the IC package 2200 to another component, such as a circuit board (e.g., a motherboard), an interposer, or another IC package, as known in the art and as discussed below with reference to FIG. 13.

The dies 2256 may take the form of any of the embodiments of the die 2002 discussed herein (e.g., may include any of the embodiments of the IC device 2100). In embodiments in which the IC package 2200 includes multiple dies 2256, the IC package 2200 may be referred to as a multichip package (MCP). The dies 2256 may include circuitry to perform any desired functionality. For example, one or more of the dies 2256 may be logic dies (e.g., silicon-based dies), and one or more of the dies 2256 may be memory dies (e.g., high bandwidth memory, and/or dies implementing one or more memory cells with non-planar memory materials, as described herein). In some embodiments, any of the dies 2256 may include one or more memory cells with non-planar memory materials, e.g., as discussed above with reference to FIG. 11; in some embodiments, at least some of the dies 2256 may not include any memory cells with non-planar memory materials.

The IC package 2200 illustrated in FIG. 12 may be a flip chip package, although other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fan-out (FO) package. Although two dies 2256 are illustrated in the IC package 2200 of FIG. 12, an IC package 2200 may include any desired number of the dies 2256. An IC package 2200 may include additional passive components, such as surface-mount resistors, capacitors, and inductors disposed on the first face 2272 or the second face 2274 of the package substrate 2252, or on either face of the interposer 2257. More generally, an IC package 2200 may include any other active or passive components known in the art.

FIG. 13 is a cross-sectional side view of an IC device assembly 2300 that may include components having one or more memory cells with non-planar memory materials in accordance with any of the embodiments disclosed herein. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. In particular, any suitable ones of the components of the IC device assembly 2300 may include any of one or more memory cells with non-planar memory materials in accordance with any of the embodiments disclosed herein; e.g., any of the IC packages discussed below with reference to the IC device assembly 2300 may take the form of any of the embodiments of the IC package 2200 discussed above with reference to FIG. 12 (e.g., may include one or more memory cells with non-planar memory materials on/over/in a die 2256).

In some embodiments, the circuit board 2302 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 13 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (e.g., as shown in FIG. 13), male and female portions of a socket, an adhesive, an underfill material, and/or any other suitable electrical and/or mechanical coupling structure.

The package-on-interposer structure 2336 may include an IC package 2320 coupled to an interposer 2304 by coupling components 2318. The coupling components 2318 may take any suitable form for the application, such as the forms discussed above with reference to the coupling components 2316. The IC package 2320 may be or include, for example, a die (the die 2002 of FIG. 10B), an IC device (e.g., the IC device 2100 of FIG. 11), or any other suitable component. In particular, the IC package 2320 may include one or more memory cells with non-planar memory materials as described herein. Although a single IC package 2320 is shown in FIG. 13, multiple IC packages may be coupled to the interposer 2304; indeed, additional interposers may be coupled to the interposer 2304. The interposer 2304 may provide an intervening substrate used to bridge the circuit board 2302 and the IC package 2320. Generally, the interposer 2304 may spread a connection to a wider pitch or reroute a connection to a different connection. For example, the interposer 2304 may couple the IC package 2320 (e.g., a die) to a BGA of the coupling components 2316 for coupling to the circuit board 2302. In the embodiment illustrated in FIG. 13, the IC package 2320 and the circuit board 2302 are attached to opposing sides of the interposer 2304; in other embodiments, the IC package 2320 and the circuit board 2302 may be attached to a same side of the interposer 2304. In some embodiments, three or more components may be interconnected by way of the interposer 2304.

The interposer 2304 may be formed of an epoxy resin, a fiberglass-reinforced epoxy resin, a ceramic material, or a polymer material such as polyimide. In some implementations, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through-silicon vias (TSVs) 2306. The interposer 2304 may further include embedded devices 2314, including both passive and active devices. Such devices may include, but are not limited to, capacitors, decoupling capacitors, resistors, inductors, fuses, diodes, transformers, sensors, ESD devices, and memory devices. In particular, one or more thermal contacts as described herein may be thermally coupled to at least some of the embedded devices 2314. More complex devices such as RF devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art. In some embodiments, the interposer 2304 may include one or more thermal contacts as described herein.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 13 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

FIG. 14 is a block diagram of an example computing device 2400 that may include one or more components with one or more memory cells with non-planar memory materials in accordance with any of the embodiments disclosed herein. For example, any suitable ones of the components of the computing device 2400 may include a die (e.g., the die 2002 (FIG. 10B)) including one or more memory cells with non-planar memory materials in accordance with any of the embodiments disclosed herein. Any of the components of the computing device 2400 may include an IC device 2100 (FIG. 11) and/or an IC package 2200 (FIG. 12). Any of the components of the computing device 2400 may include an IC device assembly 2300 (FIG. 13).

A number of components are illustrated in FIG. 14 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single SoC die.

Additionally, in various embodiments, the computing device 2400 may not include one or more of the components illustrated in FIG. 14, but the computing device 2400 may include interface circuitry for coupling to the one or more components. For example, the computing device 2400 may not include a display device 2406, but may include display device interface circuitry (e.g., a connector and driver circuitry) to which a display device 2406 may be coupled. In another set of examples, the computing device 2400 may not include an audio input device 2418 or an audio output device 2408, but may include audio input or output device interface circuitry (e.g., connectors and supporting circuitry) to which an audio input device 2418 or audio output device 2408 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The computing device 2400 may include a memory 2404, which may itself include one or more memory devices such as volatile memory (e.g., DRAM), nonvolatile memory (e.g., read-only memory (ROM)), flash memory, solid state memory, and/or a hard drive. In some embodiments, the memory 2404 may include memory that shares a die with the processing device 2402. This memory may be used as cache memory and may include embedded DRAM (eDRAM) or spin transfer torque magnetic random access memory (STT-MRAM). In various embodiments, any one of the processing device 2402 and the memory 2404 may include one or more memory cells with non-planar memory materials as described herein.

In some embodiments, the computing device 2400 may include a communication chip 2412 (e.g., one or more communication chips). For example, the communication chip 2412 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2412 may operate in accordance with other wireless protocols in other embodiments. The computing device 2400 may include an antenna 2422 to facilitate wireless communications and/or to receive other wireless communications (such as AM or FM radio transmissions).

In some embodiments, the communication chip 2412 may manage wired communications, such as electrical, optical, or any other suitable communication protocols (e.g., the Ethernet). As noted above, the communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

The computing device 2400 may include battery/power circuitry 2414. The battery/power circuitry 2414 may include one or more energy storage devices (e.g., batteries or capacitors) and/or circuitry for coupling components of the computing device 2400 to an energy source separate from the computing device 2400 (e.g., AC line power).

The computing device 2400 may include a display device 2406 (or corresponding interface circuitry, as discussed above). The display device 2406 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2408 (or corresponding interface circuitry, as discussed above). The audio output device 2408 may include any device that generates an audible indicator, such as speakers, headsets, or earbuds, for example.

The computing device 2400 may include an audio input device 2418 (or corresponding interface circuitry, as discussed above). The audio input device 2418 may include any device that generates a signal representative of a sound, such as microphones, microphone arrays, or digital instruments (e.g., instruments having a musical instrument digital interface (MIDI) output).

The computing device 2400 may include a GPS device 2416 (or corresponding interface circuitry, as discussed above). The GPS device 2416 may be in communication with a satellite-based system and may receive a location of the computing device 2400, as known in the art.

The computing device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

The following paragraphs provide various examples of the embodiments disclosed herein.

Example 1 provides an IC device that includes a FET over a support structure (e.g., a substrate, a die, a wafer, etc.), the transistor having a gate electrode material, a thin-film channel material, and a first source or drain (S/D) region and a second S/D region in the thin-film channel material; and a memory material integrated with the gate of the transistor, where the memory material is a ferroelectric (FE) material or an antiferroelectric (AFE) material. Each of the thin-film channel material and the memory material has a horizontal portion (e.g., portions 316-3 and 322-3, respectively, described herein) substantially parallel to the surface of the support structure. Furthermore, each of the thin-film channel material and the memory material has a first sidewall portion (e.g., portions 316-1 and 322-1, respectively, described herein) and a second sidewall portion (e.g., portions 316-2 and 322-2, respectively, described herein), each of the first sidewall portion and the second sidewall portion substantially perpendicular to the surface of the support structure. In such an IC device, the horizontal portion of the memory material is between the horizontal portion of the thin-film channel material and the gate electrode material, the first sidewall portion of the memory material is between the first sidewall portion of the thin-film channel material and the gate electrode material, and the second sidewall portion of the memory material is between the second sidewall portion of the thin-film channel material and the gate electrode material.

Example 2 provides the IC device according to example 1, where the transistor is a bottom-gated transistor.

Example 3 provides the IC device according to examples 1 or 2, where the gate electrode material is in a first layer over the support structure, the first S/D region and the second S/D region are in a second layer over the support structure, and the first layer is between the support structure and the second layer.

Example 4 provides the IC device according to any one of examples 1-3, where the gate electrode material has a recess from a top surface of the gate electrode material, extending towards the support structure, the horizontal portion of the memory material is at a bottom of the recess, the first sidewall portion of the memory material is at a first sidewall portion of the recess, and the second sidewall portion of the memory material is at a second sidewall portion of the recess.

Example 5 provides the IC device according to example 4, where the first S/D region is over a first portion of the top surface of the gate electrode material, the second S/D region is over a second portion of the top surface of the gate electrode material, and the first portion and the second portion of the top surface of the gate electrode material are on opposite sides of the recess.

Example 6 provides the IC device according to examples 4 or 5, where a width of the recess is a dimension of the recess between the first sidewall portion of the recess and the second sidewall portion of the recess (i.e., the width is a dimension measured substantially parallel to the support structure), a length of the recess is a dimension of the recess that is perpendicular to the width of the recess and substantially parallel to the support structure, a depth of the recess is a dimension of the recess that is perpendicular to the support structure, and a gate length of the transistor is based on a sum of the width of the recess and two times of the depth of the recess but is substantially independent of the length of the recess.

Example 7 provides the IC device according to any one of examples 4-6, where the horizontal portion of the thin-film channel material is proximate the bottom of the recess, the first sidewall portion of the thin-film channel material is proximate the first sidewall portion of the recess, the second sidewall portion of the thin-film channel material is proximate the second sidewall portion of the recess, and a gate length of the transistor includes a sum of a length of the first sidewall portion of the thin-film channel material, a length of the horizontal portion of the thin-film channel material, and a length of the second sidewall portion of the thin-film channel material.

Example 8 provides the IC device according to example 4, where each of the first S/D region and the second S/D region includes a horizontal portion proximate to the horizontal portion of the memory material at the bottom of the recess, a first sidewall portion proximate to the first sidewall portion of the memory material at the first sidewall portion of the recess, a second sidewall portion proximate to the second sidewall portion of the memory material at the second sidewall portion of the recess, a first top portion over a first portion of the top surface of the gate electrode material, and a second top portion over a second portion of the top surface of the gate electrode material, where the first portion and the second portion of the top surface of the gate electrode material are on opposite sides of the recess.

Example 9 provides the IC device according to examples 4 or 8, where a width of the recess is a dimension of the recess between the first sidewall portion of the recess and the second sidewall portion of the recess (i.e., the width is a dimension measured substantially parallel to the support structure), a length of the recess is a dimension of the recess that is perpendicular to the width of the recess and substantially parallel to the support structure, a depth of the recess is a dimension of the recess that is perpendicular to the support structure, and a gate length of the transistor is based on the length of the recess.

Example 10 provides the IC device according to example 9, where the gate length is substantially independent of the width of the recess and the depth of the recess.

Example 11 provides the IC device according to example 1, where the transistor is a vertical transistor.

Example 12 provides the IC device according to examples 1 or 11, where the first S/D region is in a first layer over the support structure, the gate electrode material is in a second layer over the support structure, the second S/D region is in a third layer over the support structure, the first layer is between the support structure and the second layer, and the second layer is between the first layer and the third layer.

Example 13 provides the IC device according to any one of examples 1 and 11-12, where the IC device further includes an insulator material, the insulator material has an opening from a top surface of the insulator material, extending towards the support structure, the horizontal portion of the thin-film channel material is at a bottom of the opening, the first sidewall portion of the thin-film channel material is at a first sidewall portion of the opening, and the second sidewall portion of the thin-film channel material is at a second sidewall portion of the opening.

Example 14 provides the IC device according to example 13, where the first sidewall portion of the thin-film channel material is between the insulator material and the first sidewall portion of the memory material, and the second sidewall portion of the thin-film channel material is between the insulator material and the second sidewall portion of the memory material.

Example 15 provides the IC device according to examples 13 or 14, where the gate electrode material is nested within the opening.

Example 16 provides the IC device according to any one of examples 13-15, where a depth of the opening is a dimension of the recess that is perpendicular to the support structure, and a gate length of the transistor is based on the depth of the opening but is substantially independent of other dimensions of the opening.

Example 17 provides the IC device according to example 1, where the transistor is a top-gated transistor.

Example 18 provides the IC device according to examples 1 or 17, where the first S/D region and the second S/D region are in a first layer over the support structure, the gate electrode material is in a second layer over the support structure, and the first layer is between the support structure and the second layer.

Example 19 provides the IC device according to any one of the preceding examples, where the first S/D region is coupled to (e.g., in electrically conductive contact with) a BL. In some such embodiments, the S/D region coupled to the BL is a source region.

Example 20 provides the IC device according to any one of the preceding examples, where the second S/D region is coupled to (e.g., in electrically conductive contact with) a SL. In some such embodiments, the S/D region coupled to the SL is a drain region.

Example 21 provides an IC device that includes a TFT over a support structure (e.g., a substrate, a die, a wafer, etc.); and a memory material between a gate electrode material of the TFT and a thin-film channel material of the TFT, where the memory material is a ferroelectric (FE) material or an antiferroelectric (AFE) material, and, in a cross-sectional side view of the IC device, the memory material has a U-shape.

Example 22 provides the IC device according to any one of the preceding examples, further including a gate dielectric material between at least a portion of the memory material and at least a portion of the gate electrode material. For example, the gate dielectric material may be a high-k dielectric material.

Example 23 provides the IC device according to any one of the preceding examples, where the gate electrode material is coupled to (e.g., in electrically conductive contact with) a WL.

Example 24 provides the IC device according to any one of the preceding examples, where the memory material is a thin-film material. For example, the memory material may have a thickness between about 1 nanometers and 10 nanometers.

Example 25 provides the IC device according to any one of the preceding examples, where the thin-film channel material has a thickness between about 1 nanometers and 10 nanometers.

Example 26 provides the IC device according to any one of the preceding examples, where the memory material includes one or more of a material including hafnium, zirconium, and oxygen (e.g., hafnium zirconium oxide), a material including silicon, hafnium, and oxygen (e.g., silicon-doped hafnium oxide), a material including germanium, hafnium, and oxygen (e.g., germanium-doped hafnium oxide), a material including aluminum, hafnium, and oxygen (e.g., aluminum-doped hafnium oxide), a material including yttrium, hafnium, and oxygen (e.g., yttrium-doped hafnium oxide), a material including lanthanum, hafnium, and oxygen (e.g., lanthanum-doped hafnium oxide), a material including gadolinium, hafnium, and oxygen (e.g., gadolinium-doped hafnium oxide), and a material including niobium, hafnium, and oxygen (e.g., niobium-doped hafnium oxide).

Example 27 provides the IC device according to any one of the preceding examples, further including an intermediate material (a non-electrically conductive material) between at least a portion of the memory material and at least a portion of the thin-film channel material.

Example 28 provides an IC package that includes an IC die, including an IC device according to any one of the preceding examples (e.g., any one of examples 1-27); and a further component, coupled to the IC die.

Example 29 provides the IC package according to example 28, where the further component is one of a package substrate, a flexible substrate, or an interposer.

Example 30 provides the IC package according to examples 28 or 29, where the further component is coupled to the IC die via one or more first-level interconnects.

Example 31 provides the IC package according to example 30, where the one or more first-level interconnects include one or more solder bumps, solder posts, or bond wires.

In further examples of the IC package according to any one of examples 28-31, the IC die includes, or is a part of, at least one of a memory device, a computing device, a wearable device, a handheld electronic device, and a wireless communications device.

Example 32 provides a computing device that includes a circuit board; and an IC die coupled to the circuit board, where the IC die includes an IC device according to any one of the preceding examples (e.g., any one of examples 1-27) and/or is included in an IC package according to any one of the preceding examples (e.g., any one of examples 28-31).

Example 33 provides the computing device according to example 32, where the computing device is a wearable computing device (e.g., a smart watch) or handheld computing device (e.g., a mobile phone).

Example 34 provides the computing device according to examples 32 or 33, where the computing device is a server processor.

Example 35 provides the computing device according to examples 32 or 33, where the computing device is a motherboard.

Example 36 provides the computing device according to any one of examples 32-35, where the computing device further includes one or more communication chips and an antenna.

Example 37 provides a method of fabricating an IC device, the method including providing a TFT over a support structure (e.g., a substrate, a die, a wafer, etc.); and providing a memory material between a gate electrode material of the TFT and a thin-film channel material of the TFT, where the memory material is a ferroelectric (FE) material or an antiferroelectric (AFE) material, and, in a cross-sectional side view of the IC device, the memory material has a U-shape.

Example 38 provides the method according to example 37, where providing the TFT and providing the memory material includes depositing the gate electrode material, forming a recess in the gate electrode material, depositing a liner of the memory material on sidewalls and bottom of the recess and over the gate electrode material around the recess, depositing a liner of the thin-film channel material over the liner of the memory material, and depositing an insulator material in a remaining portion of the recess.

Example 39 provides the method according to any one of examples 37-38, further including processes for forming the IC device according to any one of the preceding examples (e.g., for forming the IC device according to any one of examples 1-27).

Example 40 provides the method according to any one of examples 37-39, further including processes for forming the IC package according to any one of the preceding examples (e.g., for forming the IC package according to any one of examples 28-31).

Example 41 provides the method according to any one of examples 37-40, further including processes for forming the computing device according to any one of the preceding examples (e.g., for forming the computing device according to any one of examples 32-36).

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) device, comprising:
a transistor over a support structure, the transistor having a gate electrode material, a thin-film channel material, and a first source or drain (S/D) region and a second S/D region in the thin-film channel material; and
a memory material, wherein:
the memory material is a ferroelectric (FE) material or an antiferroelectric (AFE) material,
each of the thin-film channel material and the memory material has a horizontal portion substantially parallel to the support structure,
each of the thin-film channel material and the memory material has a first sidewall portion and a second sidewall portion, each of the first sidewall portion and the second sidewall portion substantially perpendicular to the support structure,
the horizontal portion of the memory material is between the horizontal portion of the thin-film channel material and the gate electrode material,
the first sidewall portion of the memory material is between the first sidewall portion of the thin-film channel material and the gate electrode material, and
the second sidewall portion of the memory material is between the second sidewall portion of the thin-film channel material and the gate electrode material.

2. The IC device according to claim 1, wherein the transistor is a bottom-gated transistor.

3. The IC device according to any one of claims 1-2, wherein:
the gate electrode material is in a first layer over the support structure,
the first S/D region and the second S/D region are in a second layer over the support structure, and
the first layer is between the support structure and the second layer.

4. The IC device according to any one of claims 1-3, wherein:
the gate electrode material has a recess from a top surface of the gate electrode material,
the horizontal portion of the memory material is at a bottom of the recess,
the first sidewall portion of the memory material is at a first sidewall portion of the recess, and
the second sidewall portion of the memory material is at a second sidewall portion of the recess.

5. The IC device according to claim 4, wherein:
the first S/D region is over a first portion of the top surface of the gate electrode material,
the second S/D region is over a second portion of the top surface of the gate electrode material, and
the first portion and the second portion are on opposite sides of the recess.

6. The IC device according to any one of claims 4-5, wherein:
a width of the recess is a dimension of the recess between the first sidewall portion of the recess and the second sidewall portion of the recess,
a length of the recess is a dimension of the recess that is perpendicular to the width of the recess and substantially parallel to the support structure,
a depth of the recess is a dimension of the recess that is perpendicular to the support structure, and
a gate length of the transistor is based on a sum of the width of the recess and two times of the depth of the recess.

7. The IC device according to any one of claims 4-6, wherein:
the horizontal portion of the thin-film channel material is proximate the bottom of the recess,
the first sidewall portion of the thin-film channel material is proximate the first sidewall portion of the recess,
the second sidewall portion of the thin-film channel material is proximate the second sidewall portion of the recess, and
a gate length of the transistor includes a sum of a length of the first sidewall portion of the thin-film channel material, a length of the horizontal portion of the thin-film channel material, and a length of the second sidewall portion of the thin-film channel material.

8. The IC device according to claim 4, wherein:
each of the first S/D region and the second S/D region includes a horizontal portion proximate to the horizontal portion of the memory material at the bottom of the recess, a first sidewall portion proximate to the first sidewall portion of the memory material at the first sidewall portion of the recess, a second sidewall portion proximate to the second sidewall portion of the memory material at the second sidewall portion of the recess, a first top portion over a first portion of the top surface of the gate electrode material, and a second top portion over a second portion of the top surface of the gate electrode material, and
the first portion and the second portion are on opposite sides of the recess.

9. The IC device according to any one of claims 1-8, wherein the transistor is a vertical transistor.

10. The IC device according to claim 1 or claim 9, wherein:
the first S/D region is in a first layer over the support structure,
the gate electrode material is in a second layer over the support structure,
the second S/D region is in a third layer over the support structure,
the first layer is between the support structure and the second layer, and
the second layer is between the first layer and the third layer.

11. The IC device according to claim 1 or claim 9, wherein:
the IC device further includes an insulator material,
the insulator material has an opening from a top surface of the insulator material,
the horizontal portion of the thin-film channel material is at a bottom of the opening,
the first sidewall portion of the thin-film channel material is at a first sidewall portion of the opening, and
the second sidewall portion of the thin-film channel material is at a second sidewall portion of the opening.

12. The IC device according to claim 11, wherein the gate electrode material is nested within the opening.

13. The IC device according to any one of claims 11-12, wherein:
a depth of the opening is a dimension of the recess that is perpendicular to the support structure, and
a gate length of the transistor is based on the depth of the opening.

14. A method of fabricating an integrated circuit (IC) device, the method comprising:
providing a thin-film transistor (TFT); and
providing a memory material between a gate electrode material of the TFT and a thin-film channel material of the TFT,
wherein:
the memory material is a ferroelectric (FE) material or an antiferroelectric (AFE) material, and
in a cross-sectional side view of the IC device the memory material has a U-shape.

15. The method according to claim 14, wherein providing the TFT and providing the memory material includes:
depositing the gate electrode material,
forming a recess in the gate electrode material,
depositing a liner of the memory material on sidewalls and bottom of the recess and over the gate electrode material around the recess,
depositing a liner of the thin-film channel material over the liner of the memory material, and
depositing an insulator material in a remaining portion of the recess.
